# EUROPEAN PATENT APPLICATION

(11) **EP 4 650 484 A1**
(43) Date of publication of application: **19.11.2025**
(21) Application number: 23916287.8
(22) Date of filing: 26.12.2023
(51) Int. Cl.: C23C 16/40, C23C 16/455, H01L 21/365, H01L 21/368

(54) **CRYSTALLINE METAL OXIDE FILM, METHOD FOR FORMING SAME, STARTING MATERIAL SOLUTION OF SAME, MULTILAYER STRUCTURE, AND SEMICONDUCTOR DEVICE**

(30) Priority: 12.01.2023 JP 2023003206
(71) Applicant: SHIN-ETSU CHEMICAL CO., LTD., Tokyo 1000005 (JP)
(72) Inventor: Sakatsume, Takahiro, Annaka-shi, Gunma 379-0195 (JP)
(74) Representative: Schicker, Silvia
(86) International application number: PCT/JP2023/046778
(87) International publication number: WO 2024/150674

(57) **Abstract**

The present invention is a film forming method for forming a crystalline metal oxide film on a substrate by heat treatment of a raw material solution atomized into a mist to generate a thermal reaction on the substrate, in which the raw material solution contains a metal raw material containing at least a metal element constituting the crystalline metal oxide film, and a carboxylic acid. This provides a film forming method capable of forming a film having excellent surface smoothness by suppressing the generation of spherical foreign matter during the formation of the film on the substrate by the heat treatment of the raw material solution atomized into the mist.

## Description

### TECHNICAL FIELD

The present invention relates to a crystalline metal oxide film, a film forming method and a raw material solution therefor, a laminated structure, and a semiconductor device.

### BACKGROUND ART

Conventionally, high vacuum film forming apparatuses capable of realizing a non-equilibrium state, such as pulsed laser deposition (PLD), molecular beam epitaxy (MBE), sputtering method, etc., have been developed. It has become possible to produce oxide semiconductors, which could not be produced by a prior melt growth method, or the like.

In addition, mist chemical vapor deposition (Mist CVD, hereinafter also referred to as "Mist CVD method") for growing a crystal on a substrate using an atomized mist-like raw material has been developed. It has become possible to produce gallium oxide (α-Ga₂O₃) having a corundum structure.

As a semiconductor with a large bandgap, α-Ga₂O₃ is expected to be applied to next-generation switching devices capable of realizing high breakdown voltage, low loss, and high heat resistance.

Regarding the Mist CVD method, Patent Document 1 discloses a tube furnace-type Mist CVD apparatus. Patent Document 2 discloses a fine channel type Mist CVD apparatus. Patent Document 3 discloses a linear source type Mist CVD apparatus. Patent Document 4 discloses a Mist CVD apparatus for a tube furnace that is different from the Mist CVD apparatus disclosed in Patent Document 1, where a carrier gas is introduced into a mist generator.

Patent Document 5 discloses a Mist CVD apparatus in which a substrate is installed above a mist generator, and a susceptor is a rotary stage provided on a hot plate.

Patent Document 6 discloses an example of forming an α-Ga₂O₃ film by a Mist CVD method in which a raw material solution is prepared by adding hydrochloric acid to an aqueous solution of a metal raw material. In this example, this solution is used to deposit a plurality of buffer films composed of α-(AlₓGa₁₋ₓ)₂O₃ films (0≤X≤1) on an α-Al₂O₃ substrate, and a high-quality α-Ga₂O₃ film is deposited thereon.

### CITATION LIST

### PATENT LITERATURE

Patent Document 1: JP H01-257337 A
Patent Document 2: JP 2005-307238 A
Patent Document 3: JP 2012-46772 A
Patent Document 4: JP 2014-234337 A
Patent Document 5: JP 2014-063973 A
Patent Document 6: JP 2022-31108 A

### SUMMARY OF INVENTION

### TECHNICAL PROBLEM

A Mist CVD method, unlike other CVD methods, enables film formation at a relatively low temperature and production of crystal structures of metastable phase, such as an α-Ga₂O₃ having a corundum structure.

However, when the present inventor performed film formation of an α-(AlₓGa₁₋ₓ)₂O₃ film and an α-Ga₂O₃ film using a method disclosed in Patent Document 6, a large number of spherical foreign matter, presumed to be byproducts of metal raw materials, were observed. The films containing a large amount of foreign matter may cause a decrease in crystallinity, which can degrade device characteristics. Therefore, it is preferable to remove the foreign matter.

Although it is possible to remove the foreign matter by polishing, the removal of the foreign matter by polishing increases the number of steps in producing semiconductor devices. Consequently, it is preferable that generation of the foreign matter is suppressed when films are formed.

The present invention has been made to solve the above-described problem. An object of the present invention is to provide a film forming method capable of forming a film having excellent surface smoothness by suppressing the generation of the spherical foreign matter during heat treatment of a misted raw material solution for forming the film on a substrate; a raw material solution used for the film formation method; and a crystalline metal oxide film having excellent surface smoothness.

### SOLUTION TO PROBLEM

To achieve the above object, the present invention provides a film forming method for forming a crystalline metal oxide film on a substrate by heat treatment of a raw material solution atomized into a mist to generate a thermal reaction on the substrate, wherein
the raw material solution contains a metal raw material containing at least a metal element constituting the crystalline metal oxide film, and a carboxylic acid.

In this way, a formation of foreign matter by a metal raw material in the raw material solution is suppressed by using the raw material solution containing carboxylic acid.

Consequently, the generation of the spherical foreign matter is suppressed when a film is formed using a Mist CVD, and the film having excellent surface smoothness can be formed.

The carboxylic acid having an acid dissociation constant with respect to water at 25°C of 2.65 or more and 4.67 or less can be used.

By having the acid dissociation constant of 2.65 or more, the formation of the foreign matter from the metal raw material is reliably suppressed. Moreover, by having the acid dissociation constant of 4.67 or less, it is possible to reliably prevent excessive increase of the carboxylic acid, which is required to suppress the generation of the spherical foreign matter, from remaining in the crystalline metal oxide film.

The carboxylic acid having 4 or fewer carbon atoms can be used.

By using the carboxylic acid having 4 or fewer carbon atoms in this way, it is possible to suppress carbon atoms in the carboxylic acid from remaining in a crystalline oxide film, and the carboxylic acid exhibits higher solubility in water, resulting in improved atomization efficiency and excellent cost-effectiveness at the film formation.

A formic acid can be used as the carboxylic acid.

The formic acid, solely composed of H, C, and O, and having the lowest molecular weight among the carboxylic acids, is advantageous in suppressing the incorporation of constituent elements of the carboxylic acid into the crystalline oxide film.

A volume ratio of the carboxylic acid in the raw material solution can be 1 vol % or more and 50 vol % or less.

By setting the volume ratio to 1 vol % or more, the suppressive effect on the foreign matter by the carboxylic acid can be reliably exerted. Moreover, by setting the volume ratio to 50 vol % or less, the suppressive effect on the foreign matter by the carboxylic acid can be sufficiently exerted, and the carbon in the carboxylic acid can be prevented from remaining in the crystalline oxide film.

A molarity of the carboxylic acid in the raw material solution can be 0.1 mol/L or more and 13.2 mol/L or less.

By setting the molarity of the carboxylic acid to 0.1 mol/L or more, the suppressive effect on the foreign matter by the carboxylic acid can be reliably exerted. Moreover, by setting the molarity of the carboxylic acid to 13.2 mol/L or less, the suppressive effect on the foreign matter by the carboxylic acid can be sufficiently exerted, and the carbon in the carboxylic acid can be suppressed from remaining in the crystalline oxide film.

The molarity of the carboxylic acid in the raw material solution can be equal to or higher than the molarity of the metal raw material in the raw material solution.

By setting the molarity in such a manner, the suppressive effect on the foreign matter by the carboxylic acid can be sufficiently exerted.

The present invention also provides a film forming method for forming a crystalline metal oxide film on a substrate by heat treatment of a raw material solution atomized into a mist to generate a thermal reaction on the substrate, wherein
the raw material solution contains a metal raw material containing at least a metal element constituting the crystalline metal oxide film, and an acid having an acid dissociation constant with respect to water at 25°C of more than -8 and less than 8.8.

In this way, by using the raw material solution containing the acid having an acid dissociation constant with respect to water at 25°C of more than -8 and less than 8.8, the formation of the foreign matter from the metal raw material in the raw material solution is suppressed.

Accordingly, when the film is formed using the Mist CVD, the generation of a spherical foreign matter can be suppressed, enabling the formation of the film having excellent surface smoothness.

The metal raw material in the raw material solution comprises at least one of gallium or aluminum as a main component.

By containing gallium or aluminum in the metal raw material, these crystalline oxide films can be formed. The main component here means a metal element with the largest atom % among the metal elements in the metal raw material.

When the metal raw material includes at least one of gallium or aluminum as a main component, the metal raw material can be an acetylacetonato complex.

By using the acetylacetonato complex as the metal raw material, the metal element dissolves more easily in the carboxylic acid in the raw material solution.

The raw material solution may be a solution containing an acetylacetonato complex of aluminum, and in this case, in MS spectrum of the raw material solution, when a peak intensity at m/z=225 is defined as I1, a peak intensity at m/z=467 is defined as I2, a peak intensity at m/z=549 is defined as I3, and a peak intensity at m/z=143 is defined as I4, (I2+I3+I4) / I1 < 0.25 is satisfied.

By satisfying such conditions, the raw material solution contains few structures in which the acetylacetonato complex has a structure crosslinked by OH or acetylacetonate, a dimerized structure, or a structure in which acetylacetonate is substituted with OH; accordingly, the generation of the spherical foreign matter, supposed to originate from these structures, can be reliably suppressed.

A temperature of the heat treatment can be 400°C or higher and 550°C or lower.

By setting the temperature for the heat treatment at 400°C or higher, the temperature required for the thermal reaction to progress during forming the film can be ensured. By setting the temperature for heat treatment at 550°C or lower, the atomized raw material can be reliably thermally reacted on the substrate.

The substrate having an area of 10 cm² or more of a surface where the crystalline metal oxide film is formed can be used.

By setting the area on the surface where the film is formed to 10 cm² or more, the crystalline metal oxide film having a large area can be formed with high quality, and productivity thereof can be improved in particular.

Moreover, the present invention provides a raw material solution used in a film forming method for forming a crystalline metal oxide film on a substrate by heat treatment of a raw material solution atomized into a mist to generate a thermal reaction on the substrate, the raw material solution comprising:
a metal raw material that contains a metal element constituting the crystalline metal oxide film; and
a formic acid.

In this way, by using the raw material solution containing the formic acid, the formation of the foreign matter from the metal raw material in the raw material solution is suppressed.

Accordingly, when the film is formed using a Mist CVD, the generation of a spherical foreign matter can be suppressed, enabling the formation of the film having excellent surface smoothness.

Moreover, the present invention provides a raw material solution used in a film forming method for forming a crystalline metal oxide film on a substrate by heat treatment of a raw material solution atomized into a mist to generate a thermal reaction on the substrate, the raw material solution comprising:
a metal raw material that contains a metal element constituting the crystalline metal oxide film; and
an acid having an acid dissociation constant with respect to water at 25°C of more than -8 and less than 8.8.

In this way, when the raw material solution contains the acid having the acid dissociation constant with respect to water at 25°C of more than -8 and less than 8.8, the formation of the foreign matter from the metal raw material in the raw material solution is suppressed.

Accordingly, when the film is formed using a Mist CVD, the generation of a spherical foreign matter can be suppressed, enabling the formation of the film having excellent surface smoothness.

The metal raw material in the raw material solution can comprise at least one of Ga or Al as a main component.

By containing gallium or aluminum in the metal raw material, these crystalline oxide films can be formed. The main component here means a metal element with the largest atom % among the metal elements in the metal raw material.

When gallium or aluminum is included in the metal raw material, the metal raw material can be the acetylacetonato complex.

By using the acetylacetonato complex as the metal raw material, the metal element dissolves more easily in the formic acid in the raw material solution.

The raw material solution may be a solution containing an acetylacetonato complex of aluminum, and in this case, in MS spectrum of the raw material solution, when a peak intensity at m/z=225 is defined as I1, a peak intensity at m/z=467 is defined as I2, a peak intensity at m/z=549 is defined as I3, and a peak intensity at m/z=143 is defined as I4, (I2+I3+I4) / I1 < 0.25 is satisfied.

By satisfying such conditions, the raw material solution contains few structures in which the acetylacetonato complex has a structure (I2) crosslinked by OH or acetylacetonate, a dimerized structure (I3), or a structure (I4) in which acetylacetonate is substituted with OH; accordingly, the generation of the spherical foreign matter, supposed to originate from these structures, can be reliably suppressed.

Moreover, the present invention provides a crystalline metal oxide film comprising at least one of gallium or aluminum as a main component, wherein
a number density of a spherical foreign matter or an agglomeration of spherical foreign matter present on a surface of the crystalline metal oxide film is 621 units/cm² or less.

Such a crystalline metal oxide film can be suitably used for a semiconductor device due to the excellent smoothness of the film.

In this case,
the number density of the spherical foreign matter or the agglomeration of spherical foreign matter present on the surface of the crystalline metal oxide film can be 54 units/cm² or less.

Such a crystalline metal oxide film can be further suitably used for the semiconductor device due to the further improved smoothness of the film.

In this case, the crystalline metal oxide film can have a corundum structure.

Such a crystalline metal oxide film can be a crystalline metal oxide film having the corundum structure with excellent smoothness.

In this case, a surface area of the crystalline metal oxide film can be 10 cm² or more.

Such a crystalline metal oxide film has excellent smoothness and a large area, and thus can be further suitably used for the semiconductor device.

In this case, a laminated structure can comprise a substrate, and the crystalline metal oxide film formed via a buffer layer on the substrate.

Such a laminated structure can be suitably used for the semiconductor device due to the excellent smoothness of the film.

In this case, a semiconductor device can comprise at least one of the crystalline metal oxide film or the laminated structure.

Such a semiconductor device has excellent smoothness of the film, which results in the semiconductor device having excellent electrical characteristics.

In this case, the semiconductor device is any of a semiconductor laser, a diode, or a transistor.

Such a semiconductor device serves as the semiconductor laser, the diode, or the transistor having excellent electrical characteristics.

### ADVANTAGEOUS EFFECTS OF INVENTION

As described above, according to the inventive film forming method, a film having excellent surface smoothness can be formed by suppressing the generation of the spherical foreign matter during heat treatment of a misted raw material solution for forming the film on a substrate.

Moreover, according to the inventive raw material solution, a film having excellent surface smoothness can be formed by suppressing the generation of the spherical foreign matter during heat treatment of a misted raw material solution for forming the film on a substrate.

Accordingly, in the Mist CVD method, it is possible to form the film having a small amount of the spherical foreign matter on the surface and excellent smoothness by a simple and convenient method.

Moreover, according to the inventive crystalline metal oxide film, the film has excellent smoothness, and thus can be suitably used for the semiconductor device.

### BRIEF DESCRIPTION OF DRAWINGS

FIG. 1 is an example illustrating a film forming apparatus used in a film forming method according to the present invention.
FIG. 2 is an example illustrating a mist forming unit of a film forming apparatus used in a film forming method according to the present invention.
FIG. 3 is another example illustrating a film forming apparatus used in a film forming method according to the present invention.
FIG. 4 is an example of a SEM image of a spherical foreign matter on an α-(Al_{X}Ga_{1-X})₂O₃ film (0≤X≤1).
FIG. 5 is another example of a SEM image of a spherical foreign matter on an α-(AlₓGa₁₋ₓ)₂O₃ film (0≤X≤1).
FIG. 6 shows a relation between an amount of a formic acid added to a raw material solution and foreign matter density in Examples and Comparative Examples.
FIG. 7 shows a relation between an acid dissociation constant of carboxylic acid contained in a raw material solution with respect to water and foreign matter density in Examples and Comparative Examples.
FIG. 8 shows a MS spectrum of a raw material solution used in Example 1.
FIG. 9 shows a MS spectrum of a raw material solution used in Comparative Example 1.
FIG. 10 shows a MS spectrum of a raw material solution used in Comparative Example 2.
FIG. 11 is a view illustrating a form of a structure of a laminated structure according to the present invention.
FIG. 12 is a view illustrating an example of a Schottky barrier diode according to the present invention.
FIG. 13 is a view illustrating an example of a high electron mobility transistor according to the present invention.
FIG. 14 is a view illustrating an example of a semiconductor field effect transistor according to the present invention.
FIG. 15 is a view illustrating an example of an insulated gate type bipolar transistor according to the present invention.
FIG. 16 is a view illustrating an example of a light-emitting diode according to the present invention.
FIG. 17 shows a relation between a foreign matter density and a yield in Examples and Comparative Examples (semiconductor device having a breakdown voltage of 600 V or more).
FIG. 18 shows a relation between a foreign matter density and a yield in Examples and Comparative Examples (semiconductor device having a breakdown voltage of 1200 V or more).

### DESCRIPTION OF EMBODIMENTS

Hereinafter, the present invention will be described in detail. However, the present invention is not limited thereto.

As described above, a film forming method capable of forming a film having excellent surface smoothness by suppressing the generation of the spherical foreign matter during heat treatment of a misted raw material solution for forming the film on a substrate, a raw material solution used for this method, and a crystalline metal oxide film having excellent surface smoothness have been desired.

To solve the above problem, the present inventor has earnestly studied and found that by virtue of a film forming method for forming a crystalline metal oxide film on a substrate by heat treatment of a raw material solution atomized into a mist to generate a thermal reaction on the substrate, in which the raw material solution contains a metal raw material containing at least a metal element constituting the crystalline metal oxide film, and a carboxylic acid, it is possible to form a film having excellent surface smoothness by suppressing the generation of the spherical foreign matter during the formation of the film on the substrate by the heat treatment of the raw material solution atomized into the mist. This finding has led to the completion of the present invention.

Moreover, the present inventor has earnestly studied to solve the above problem and found that by virtue of a film forming method for forming a crystalline metal oxide film on a substrate by heat treatment of a raw material solution atomized into a mist to generate a thermal reaction on the substrate, in which the raw material solution contains a metal raw material containing at least a metal element constituting the crystalline metal oxide film, and an acid having an acid dissociation constant with respect to water at 25°C of more than -8 and less than 8.8, it is possible to form a film having excellent surface smoothness by suppressing the generation of the spherical foreign matter during the formation of the film on the substrate by the heat treatment of the raw material solution atomized into the mist. This finding has led to the completion of the present invention.

Moreover, the present inventor has earnestly studied to solve the above problem and found that by virtue of a raw material solution used in a film forming method for forming a crystalline metal oxide film on a substrate by heat treatment of a raw material solution atomized into a mist to generate a thermal reaction on the substrate, the raw material solution including a metal raw material that contains a metal element constituting the crystalline metal oxide film, and a formic acid, it is possible to form a film having excellent surface smoothness by suppressing the generation of the spherical foreign matter during the formation of the film on the substrate by the heat treatment of the raw material solution atomized into the mist. This finding has led to the completion of the present invention.

Moreover, the present inventor has earnestly studied to solve the above problem and found that by virtue of a raw material solution used in a film forming method for forming a crystalline metal oxide film on a substrate by heat treatment of a raw material solution atomized into a mist to generate a thermal reaction on the substrate, the raw material solution including a metal raw material that contains a metal element constituting the crystalline metal oxide film, and an acid having an acid dissociation constant with respect to water at 25°C of more than -8 and less than 8.8, it is possible to form a film having excellent surface smoothness by suppressing the generation of the spherical foreign matter during the formation of the film on the substrate by the heat treatment of the raw material solution atomized into the mist. This finding has led to the completion of the present invention.

Moreover, the present inventor has earnestly studied to solve the above problem and found that by virtue of a crystalline metal oxide film including at least one of gallium or aluminum as a main component, in which a number density of a spherical foreign matter or an agglomeration of the spherical foreign matter present on a surface of the crystalline metal oxide film is 621 units/cm² or less, the film can be suitably used for a semiconductor device because the film has excellent smoothness. This finding has led to the completion of the present invention.

Hereinafter, the present invention is described with reference to the drawings.

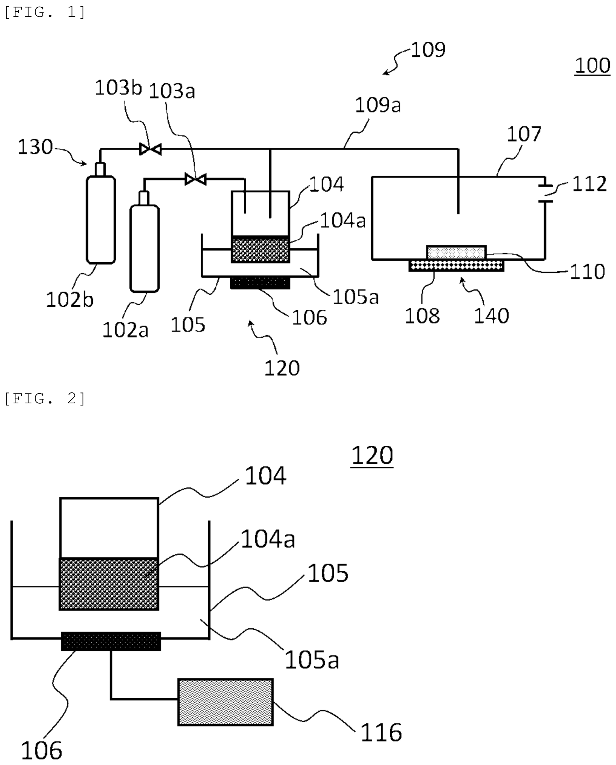

First, an example of a film forming apparatus 100 used for an inventive film forming method with reference to FIG. 1.

### (Film Forming Apparatus)

FIG. 1 shows an example of the film forming apparatus 100 usable in the film forming method according to the present invention. The film forming apparatus 100 includes: a mist forming unit 120 that atomizes a raw material solution 104a into mist to generate the mist; a carrier gas supply unit 130 that supplies a carrier gas to transport the mist; a film forming unit 140 that heat-treats the mist to form a film on a substrate; and a transport portion 109 that connects the mist forming unit 120 and the film forming unit 140 in which the mist is transported by the carrier gas. Further, the film forming apparatus 100 may be controlled in operation thereof by providing a control unit (not shown) for controlling a whole or a part of the film forming apparatus 100.

### (Mist Forming Unit)

In the mist forming unit 120, the raw material solution 104a is atomized into the mist to generate the mist. The mist forming means is not particularly limited as long as the raw material solution 104a can be atomized into the mist, and may be any known mist forming means. However, it is preferable to use mist-forming means utilizing ultrasonic vibration. This is because it enables more stable atomization of the solution into the mist.

FIG. 2 shows an example of the mist forming unit 120 using ultrasonic vibration. The mist forming unit 120 may include, for example, a mist generation source 104 that stores the raw material solution 104a, a container 105 that can be filled with a medium capable of transmitting ultrasonic vibration, such as water 105a, and an ultrasonic vibrator 106 attached to a bottom surface of the container 105.

Specifically, the mist generation source 104, which consists of the container that stores the raw material solution 104a, is housed within the container 105, which stores water 105a, using a support (not shown). The ultrasonic vibrator 106 is provided at the bottom portion of the container 105, and the ultrasonic vibrator 106 and an oscillator 116 are connected to each other. Then, when the oscillator 116 is operated, the ultrasonic vibrator 106 vibrates, and the ultrasonic waves propagate into the mist generation source 104 via the water 105a, and then the raw material solution 104a is atomized into the mist.

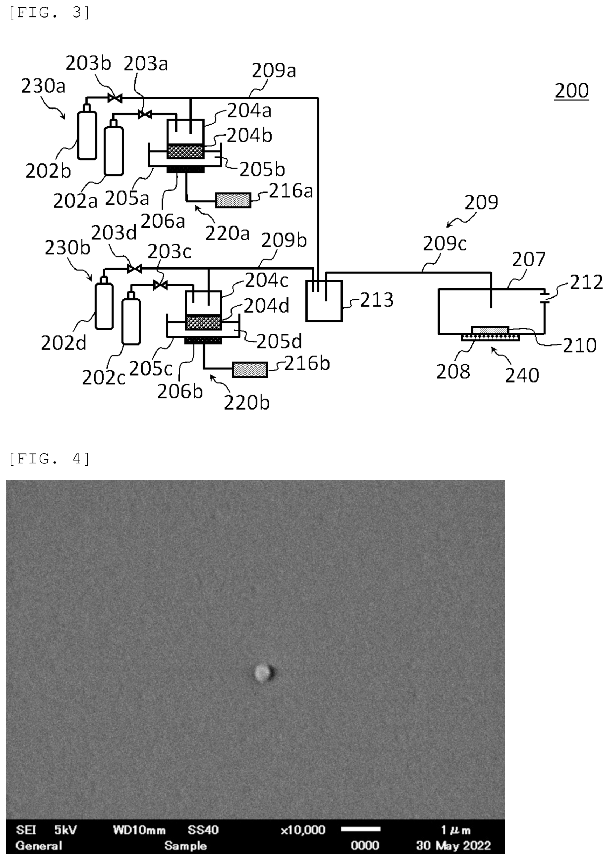

Note that when forming a crystalline metal oxide film composed of 2 or more types of metals (for example, α-(AlₓGa₁₋ₓ)₂O₃ film (0≤X<1)), the raw material solution 104a, in which each metal raw material solution is mixed, may be stored in the mist generation source 104 of one mist forming unit 120 and then atomized into mist. Alternatively, a plurality of mist forming units, such as mist forming units 220a and 220b as shown in FIG. 3, may be provided, and the respective metal raw material solutions may be individually stored in mist generation sources 204a and 204c of different mist forming units and atomized into mist separately.

When a plurality of mist forming units are provided, a mist mixer 213 for mixing respective misted raw material solutions may be provided as shown in FIG. 3, or the misted raw material solutions may be supplied to a film forming chamber 207 separately without providing the mist mixer 213 (not shown).

### (Carrier Gas Supply Unit)

The carrier gas supply unit 130 shown in FIG. 1 includes a carrier gas source 102a for supplying the carrier gas and may be provided with a flow rate control valve 103a for adjusting a flow rate of the carrier gas sent out from the carrier gas source 102a. In addition, a diluent carrier gas source 102b for supplying a diluent carrier gas and a flow rate control valve 103b for adjusting a flow rate of the diluent carrier gas sent out from the diluent carrier gas source 102b may also be provided as needed.

The type of the carrier gas is not particularly limited and can be appropriately selected depending on the film formed. For example, oxygen, ozone, an inert gas such as nitrogen or argon, or a reducing gas such as hydrogen gas or forming gas can be exemplified.

Further, the type of the carrier gas may be one type or two or more types. For example, a diluted gas obtained by diluting the same gas as the first carrier gas with another gas (for example, diluted 10-fold) may be further used as the second carrier gas, or air may be used.

Supply ports of carrier gas may not be only at one port but also at two or more ports.

The flow rate of the carrier gas is not particularly limited. For example, when a film is formed on a substrate having a diameter of 4 inches, it is preferably 1 to 80 L/min, and more preferably 4 to 40 L/min. Note that the flow rate of the carrier gas in the present invention is a measured value at 20°C and atmospheric pressure, and when measured at other temperatures or pressure, or when a different type of flow rate (mass flow rate or the like) is measured, it can be converted to a volumetric flow rate at 20°C and atmospheric pressure using equation of state of the gas.

### (Film Forming Unit)

The film forming unit 140 heats the mist to generate the thermal reaction to form a film on a part or all of the surface of a substrate 110 (crystalline substrate). The film forming unit 140 can be provided with, for example, a film forming chamber 107, the substrate 110 (crystalline substrate) installed in the film forming chamber 107, and a hot plate 108 for heating the substrate 110 (crystalline substrate).

The hot plate 108 may be provided outside the film forming chamber 107 as shown in FIG. 1, or may be provided inside the film forming chamber 107. Further, the film forming chamber 107 may be provided with an exhaust gas exhaust port 112 at a position that does not affect the supply of mist to the substrate 110 (crystalline substrate).

Moreover, the substrate 110 (crystalline substrate) may be installed on an upper surface of the film forming chamber 107 for face-down, or the substrate 110 (crystalline substrate) may be installed on a bottom surface of the film forming chamber 107 for face-up. FIG. 1 exemplifies a case of the face-up.

The thermal reaction is only required that the mist reacts by heating, and the reaction conditions or the like are not particularly limited. The conditions can be appropriately selected according to the raw material and the film formed. Specifically, the lower limit of temperature for the heat treatment of the mist during the film formation, that is, the lower limit of a heating temperature of the mist by the hot plate 108, is a temperature at which the reaction of the mist progresses by heating. The upper limit of temperature of the heat treatment is the temperature at which the mist reacts reliably on the substrate 110 without generating vapor phase reaction or the like. More specific heat treatment temperatures can be in a range of 120°C or higher and 600°C or lower, preferably in the range of 200°C or higher and 600°C or lower, and more preferably in the range of 400°C or higher and 550°C or lower.

The thermal reaction may be performed under any atmosphere of a vacuum, a non-oxygen atmosphere, a reducing gas atmosphere, an air atmosphere, or an oxygen atmosphere, and may be appropriately set according to the film formed. In addition, the reaction pressure may be performed under any condition of atmospheric pressure, pressurized, or reduced pressure, but the film formation under atmospheric pressure is preferable because the apparatus configuration can be simplified.

### (Transport Portion)

The transport portion 109 connects the mist forming unit 120 and the film forming unit 140. The mist is transported by the carrier gas from the mist generation source 104 of the mist forming unit 120 to the film forming chamber 107 of the film forming unit 140 via the transport portion 109. The transport portion 109 can be, for example, a supply pipe 109a. As the supply pipe 109a, for example, a quartz pipe or a pipe made of resin can be used.

### (Raw Material Solution)

The raw material solution 104a is not particularly limited as long as the solution thereof contains at least the metal raw material containing the metal element constituting the crystalline metal oxide film, and the carboxylic acid or the acid having the acid dissociation constant with respect to water at 25°C of more than -8 and less than 8.8, and may be an inorganic or an organic material. Metals or metal compound solutions are suitably used for the raw material solution 104a, and the solution containing one or more metals selected from gallium, iron, indium, aluminum, vanadium, titanium, chromium, rhodium, nickel, and cobalt can be used.

By containing these metals, the crystalline metal oxide films made of these metals can be formed. In particular, by using at least one of gallium or aluminum as a main component, the crystalline oxide films made of these metals, such as an α-Ga₂O₃ film or an α-Al₂O₃ film, can be formed. The main component here means a metal element having the largest atom % among the metal elements in the metal raw material.

The raw material solution 104a is not particularly limited as long as the solution can atomize the metal solution described above into the mist, but the raw material solution 104a in which the metal is dissolved or dispersed in an organic solvent or water in a form of a complex or a salt can be used. However, it is preferable to dissolve the metal complex in water. This is because of excellent atomization efficiency and cost.

As the form of the complex, an acetylacetonate complex, a carbonyl complex, an ammine complex, a hydride complex, or the like can be exemplified.

In particular, when the metal raw material includes at least one of gallium or aluminum as a main component, the metal raw material can be an acetylacetonato complex.

By using the acetylacetonato complex as the metal raw material, the metal element dissolves more easily in the carboxylic acid in the raw material solution 104a.

As the form of salts, metal chloride salt, metal bromide salt, metal iodide salt, or the like, can be exemplified. Moreover, a solution of the above metal dissolved in a hydrobromic acid, a hydrochloric acid, a hydrogen iodide acid, or the like can also be used as an aqueous salt solution.

A raw material concentration of the metal raw material as a solute is appropriately from 0.01 mol/L to 1 mol/L, preferably from 0.05 mol/L to 0.5 mol/L, and more preferably from 0.08 mol/L to 0.30 mol/L. When the concentration is within these ranges, it is possible to maintain a sufficient film formation rate while more effectively suppressing the formation of foreign matter.

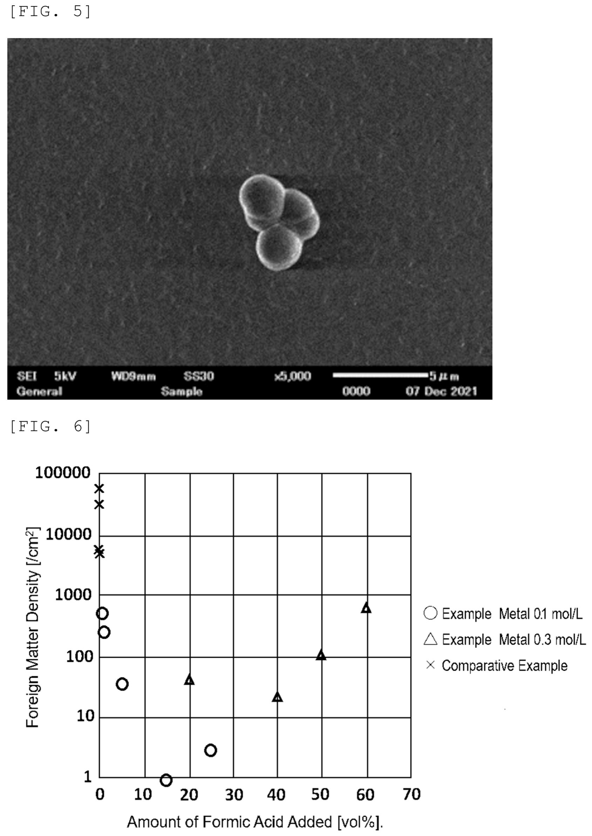

Moreover, the inventive raw material solution 104a contains either the carboxylic acid or the acid having the acid dissociation constant with respect to water at 25°C of more than -8 and less than 8.8. By containing such acids, the generation of the spherical foreign matter, as shown in FIG. 4, due to a side reaction of the metal raw material, as well as the formation of the foreign matter due to the agglomeration of the spherical foreign matter, as shown in FIG. 5, can be suppressed. Therefore, when performing the film formation using the Mist CVD, it is possible to suppress the generation of the spherical foreign matter and form the film with the excellent surface smoothness.

Note that FIGs. 4 and 5 are SEM images of the foreign matter formed on the films when the α-(Al_{X}Ga₁₋ₓ)₂O₃ film (0≤X<1) is formed using the Mist CVD.

Note that the spherical foreign matter, such as that shown in FIGs. 4 and 5, can be identified in terms of the shape and number thereof by shape observation or investigation of the number generated using not only SEM as shown in FIGs. 4 and 5, but also an electron microscope such as TEM, an optical microscope, a surface inspection apparatus that detect defects based on brightness contrast, or a surface inspection apparatus using image recognition AI for defect detection through machine learning. However, the observation method and the method for counting the number thereof are not particularly limited.

Although a mechanism for forming the spherical foreign matter and a mechanism by which the carboxylic acid or the acid having the acid dissociation constant with respect to water at 25°C of more than -8 and less than 8.8 can suppress the formation of the spherical foreign matter, remain unclear, the following mechanism can be considered.

First, based on a result of measuring an MS spectrum obtained by ionizing the raw material solution 104a, in the raw material solution 104a, to which the carboxylic acid or the acid having the acid dissociation constant with respect to water at 25°C of more than -8 and less than 8.8 is not added, a dimer of the raw material is observed. In contrast, in the raw material solution 104a, to which the carboxylic acid or the acid having the acid dissociation constant with respect to water at 25°C of more than -8 and less than 8.8 is added, almost no dimer of the raw material is observed.

Moreover, when a stronger acid (such as hydrochloric acid) than the carboxylic acid or the acid having the acid dissociation constant with respect to water at 25°C of more than -8 and less than 8.8 is used, a structure in which a hydroxide or a strong acid is coordinated is observed. At the aforementioned heat treatment temperature, it is presumed that such dimers or raw material components coordinated with the hydroxide or the strong acid form the foreign matter on the substrate instead of forming the crystalline metal oxide film.

For example, when measuring the MS spectrum of the raw material solution 104a, containing an aluminum acetylacetonate as the metal raw material, in a solution to which the carboxylic acid or the acid having the acid dissociation constant with respect to water at 25°C of more than -8 and less than 8.8 is added, a strong peak at m/z=225 likely corresponding [Al(acac)₂⁺] in which one acac is desorbed from Al(acac)₃ being the raw material, appears particularly prominent. In contrast, in a solution to which the carboxylic acid or the acid having the acid dissociation constant with respect to water at 25°C of more than -8 and less than 8.8 is not added, peaks appear at m/z=467 and m/z=549, and the like, which are considered to correspond to dimerized structures of the raw materials such as [Al(acac)₂-OH-Al(acac)₂⁺] or [Al(acac)₂-acac-Al(acac)₂⁺] which are [Al(acac)₂⁺] crosslinked by OH or acac.

In addition, when hydrochloric acid(the acid dissociation constant is -8), being a strong acid, is added, peaks such as a peak at m/z=143 likely corresponding to [Al(acac)(OH)⁺], where acac in [Al(acac)₂⁺] is substituted with OH, appear.

It is supposed that such dimers or raw material components coordinated with the hydroxide or the strong acid form the spherical foreign matter instead of the crystalline metal oxide film on the substrate. This is considered to be the forming mechanism of the spherical foreign matter.

Moreover, in the raw material solution 104a to which the carboxylic acid or the acid having the acid dissociation constant with respect to water at 25°C of more than -8 and less than 8.8 is added, few peaks originated from the dimer of the raw material component or the raw material component coordinated with the hydroxide or the strong acid can be observed. Accordingly, it is supposed that the generation of them is suppressed by the carboxylic acid or the acid having the acid dissociation constant with respect to water at 25°C of more than -8 and less than 8.8, thereby suppressing the formation of the foreign matter. This is considered to be the mechanism by which the carboxylic acid or the acid having the acid dissociation constant with respect to water at 25°C of more than -8 and less than 8.8 can suppress the formation of the spherical foreign matter.

With such a mechanism, it is considered that the formation of the spherical foreign matter can be suppressed by the carboxylic acid or the acid having the acid dissociation constant with respect to water at 25°C of more than -8 and less than 8.8. Accordingly, the raw material solution 104a containing the aluminum acetylacetonate as the metal raw material is particularly preferable, as the foreign matter formation is more effectively suppressed when the amount of the dimer or the raw material component coordinated with hydroxide or strong acid is decreased.

Therefore, when the raw material solution 104a is a solution containing the acetylacetonato complex of aluminum, and when a peak intensity at m/z=225 is defined as I1, a peak intensity at m/z=467 is defined as I2, a peak intensity at m/z=549 is defined as I3, and a peak intensity at m/z=143 is defined as I4 in the MS spectrum of the raw material solution 104a, it is preferable that (I2+I3+I4) / I1 < 0.25.

It is more preferable that (I2+I3+I4) / I1 < 0.1, further preferably (I2+I3+I4) / I1 <0 .05, and most preferably (I2+I3+I4) / I1 =0 (all of I1, I3, and I4 are less than 5.0×10³, which represents the lower limit of detection).

In this way, by using the raw material solution 104a that contain a small amount of acetylacetonate complex having a structure (m/z=467) crosslinked by OH or acetylacetonate, a dimerized structure (m/z=549), or a structure (m/z=143) in which acetylacetonate is substituted with OH, the generation of the spherical foreign matter supposed to originate from these structures, can be reliably suppressed.

Note that a method for obtaining the MS spectrum or an ionization method is not particularly limited. The ionization methods include, e.g., an electron ionization method, a chemical ionization method, a fast atom bombardment, a matrix-assisted laser desorption/ionization, electrospray ionization method.

The type of carboxylic acid according to the present invention is not particularly limited. The examples may include saturated monocarboxylic acids (such as a formic acid, an acetic acid, a propionic acid, a butyric acid, or a valeric acid), unsaturated monocarboxylic acids (such as an acrylic acid, a crotonic acid, or a methacrylic acid), dicarboxylic acids having two carboxyl groups (such as an oxalic acid, a malonic acid, a succinic acid, a glutaric acid, an adipic acid, or a maleic acid), tricarboxylic acids having three carboxyl groups (such as a citric acid), hydroxy acids having a hydroxyl group in addition to a carboxyl group (such as a lactic acid, a malic acid, a tartaric acid, or a glycolic acid), aromatic carboxylic acids having a phenyl group (such as a benzoic acid, an isophthalic acid, or a terephthalic acid), or carboxylic acids having a carbonyl group (such as a glyoxylic acid or a levulinic acid).

Moreover, a derivative may be used, in which some of the hydrogen atoms of the acids described above are substituted with electron-withdrawing functional groups such as a halogen, a vinyl group, a cyano group, or a nitro group. For example, in the case of the acetic acid (CH₃COOH), such derivatives include a monochloroacetic acid (CH₂ClCOOH), a dichloroacetic acid (CHCl₂COOH), and a trichloroacetic acid (CCl₃COOH), in which the hydrogen atoms of CH₃ are substituted with chlorine. That is, "carboxylic acid" as referred to in the present invention includes the derivative.

Other derivatives include a fluoroacetic acid, in which some of the hydrogen atoms of the acid described above are similarly substituted with a fluorine; a bromoacetic acid substituted with a bromine; an iodoacetic acid substituted with an iodine; a cyanoacetic acid substituted with a cyano group; a vinylacetic acid substituted with a vinyl group; and a nitroacetic acid substituted with a nitro group. By substituting with the electron-withdrawing functional group, an acidity of -COOH moiety can be increased.

Moreover, it is also possible to use an acyl halide in which the OH moiety of the carboxy group in the above acids is substituted with the halogen, or a carboxylate salt, which is a neutralization reaction product of the above acids with a base such as NaOH or ammonia water, and hydrolyze thereof to produce the carboxylic acid. However, it is preferable to use the carboxylic acid. This is because the procedure is less complicated than necessary, and the generation of the foreign matter can be easily suppressed.

The carboxylic acid according to the present invention, which is in liquid form under standard temperature and pressure, may be used as is, and may be mixed with the organic solvent or water. Moreover, when the carboxylic acid is in a solid form under standard temperature and pressure, this acid may be used in a dissolved state in the organic solvent or water, but dissolution in water is preferable. This is because of the superior atomization efficiency and cost effectiveness.

The carboxylic acid according to the present invention is, for example, the carboxylic acid having 5 or fewer carbon atoms, but the carboxylic acid having 4 or fewer carbon atoms is preferable. A smaller number of carbon atoms results in fewer residual carbon atoms in the crystalline metal oxide film. At the same time, such a carboxylic acid is more water-soluble, which enables atomization easier and contributes to lower film-forming costs.

Moreover, the carboxylic acid according to the present invention is preferably a carboxylic acid composed of only H, C, and O. This is because the undesirable impurity incorporation in the crystalline metal oxide film can be suppressed.

Among such carboxylic acids, the carboxylic acid according to the present invention is preferably the formic acid.

Since the formic acid is composed of only H, C, and O, and is the carboxylic acid having the smallest molecular weight, thus, elements in the carboxylic acid are less likely to be incorporated into the crystalline oxide film when compared with the carboxylic acid having a large molecular weight, which is advantageous for suppressing such an incorporation.

Moreover, the carboxylic acid according to the present invention preferably has the acid dissociation constant with respect to water at 25°C of 2.65 or more and 4.67 or less. When the acid dissociation constant is within such a range, the formation of OH⁻ can be effectively suppressed, and the remaining carbon atoms in the film can be effectively suppressed.

By having the acid dissociation constant of 2.65 or more, the formation of the foreign matter from the metal raw material can be reliably suppressed. Moreover, by having the acid dissociation constant of 4.67 or less, it is possible to reliably prevent excessive increase of the carboxylic acid, which is required to suppress the generation of the spherical foreign matter, from remaining in the crystalline metal oxide film.

Note that the acid dissociation constant refers to a negative common logarithm pKa of an equilibrium constant Ka for a dissociation reaction in which a hydrogen ion is released from the acid. Moreover, in the present invention, the acid dissociation constant with respect to water refers to a value described in the Handbook of Chemistry. In the case of the carboxylic acid with a multistep ionization, the value for the acid dissociation constant of a first dissociation step is used. When the value is not described, the value may be determined experimentally by neutralization titration, an absorption photometry method, capillary electrophoresis, or the like.

The carboxylic acids, which have the acid dissociation constant of 2.65 or more and 4.67 or less, include the formic acid (3.55), the acetic acid (4.56), the propionic acid (4.67), the butyric acid (4.63), the valeric acid (4.64), the acrylic acid (4.26), the malonic acid (2.65), the succinic acid (4.00), the glutaric acid (4.13), the adipic acid (4.26), the citric acid (2.87), the lactic acid (3.66), the malic acid (3.24), the tartaric acid (D-form 2.82, L-form 2.99), the glycolic acid (3.63), the benzoic acid (4.20), the isophthalic acid (3.50), the terephthalic acid (3.54), the glyoxylic acid (3.18), the levulinic acid (4.44), a chloroacetic acid (2.68), a 2-chloropropionic acid (2.71), a 3-chloropropionic acid (3.92), the vinylacetic acid (4.12), the bromoacetic acid (2.72), and the iodoacetic acid (2.98), though the carboxylic acids are not limited thereto. The numerical values in parentheses represent the acid dissociation constant for the first dissociation step.

Moreover, the concentration of the carboxylic acid according to the present invention is not particularly limited as long as the concentration falls within a range in which the suppressive effect on the foreign matter by the carboxylic acid can be exerted and carbon is unlikely to remain in the crystalline oxide film.

For example, the concentration of the carboxylic acid according to the present invention is 60 vol % or less in a volume percentage with respect to the total volume of the solution. Moreover, it is preferably 1 vol % or more and 50 vol % or less, and more preferably 5 vol % or more and 40 vol % or less.

By setting the volume ratio to 1 vol % or more, the suppressive effect on the foreign matter by the carboxylic acid can be reliably exerted. Moreover, by setting the volume ratio to 50 vol % or less, the suppressive effect on the foreign matter by the carboxylic acid can be sufficiently exerted, and the carbon in the carboxylic acid can be suppressed from remaining in the crystalline oxide film.

Moreover, the molarity of the carboxylic acid in the raw material solution according to the present invention is not particularly limited, but, for example, is 15.8 mol/L or less. Furthermore, it is preferably 0.1 mol/L or more and 13.2 mol/L or less, and more preferably 1.3 mol/L or more and 10.5 mol/L or less.

By setting the molarity of the carboxylic acid to 0.1 mol/L or more, the suppressive effect on the foreign matter by the carboxylic acid can be reliably exerted. Moreover, by setting the molarity of the carboxylic acid to 13.2 mol/L or less, the suppressive effect on the foreign matter by the carboxylic acid can be sufficiently exerted, and the carbon in the carboxylic acid can be suppressed from remaining in the crystalline oxide film.

Note that the molarity of the carboxylic acid in the raw material solution is preferably equal to or higher than the molarity of the metal raw material in the raw material solution 104a.

This is because, by setting such a molarity, the suppressive effect on the foreign matter by the carboxylic acid can be sufficiently exerted.

Moreover, the acid having the acid dissociation constant with respect to water at 25°C of more than -8 and less than 8.8, according to the present invention, is not particularly limited as long as the acid dissociation constant is more than -8 and less than 8.8. It is preferably 0.77 or more and less than 8.8, and more preferably 2.0 or more and 7.53 or less. Such acids include, but are not limited to, the carboxylic acids described earlier, as well as a hypobromous acid (7.53), a hypochlorous acid (7.53), a chlorous acid (2.53), a carbonic acid (6.35), a hydrofluoric acid (3.17), an iodic acid (0.77), a phosphinic acid (1.23), a phosphonic acid (1.5), a phosphoric acid (2.15), a diphosphoric acid (0.8), a tripolyphosphoric acid (2.0), a hydrogen sulfide (7.02), and a sulfurous acid (1.91).

By using the acid in a range of these acid dissociation constants, it is possible to suppress the formation of the foreign matter from the metal raw material.

Moreover, the raw material solution 104a may contain a dopant. The dopant is not particularly limited. For example, n type dopants such as tin, germanium, silicon, titanium, zirconium, vanadium, or niobium, or p type dopants such as copper, silver, tin, iridium, or rhodium can be mentioned. The concentration of the dopant may be, for example, about 1.0×10⁻⁹ to 1.0 mol/L, and even the concentration can be as low concentration of about 1.0×10⁻⁷ mol/L or less, or as high concentration of about 0.01 mol/L or more.

### (Substrate)

The substrate 110 shown in FIG. 1 is not particularly limited as long as the substrate has a surface on which the crystalline metal oxide film can be formed, and can support the formed metal oxide film. A known substrate may be used. The substrate may be made of an insulator, a conductor, a semiconductor, a single crystal, or a polycrystal.

The specific substrate 110 is made of, for example, polysulfone, polyether sulfone, polyphenylene sulfide, polyetheretherketone, polyimide, polyetherimide, fluororesin, metals such as iron, aluminum, stainless steel, gold or the like, silicon, sapphire, quartz, glass, gallium oxide, lithium niobate, lithium tantalate, but the substrate 110 is not limited to these.

Moreover, it is preferable to use the substrate 110 in which the metal element contained in the substrate 110 in the largest amount of the metal element in terms of atom % is aluminum. Among such substrates, a sapphire wafer is preferably used in view of quality and cost.

A plane orientation of a main surface of the substrate 110 is not particularly limited, and in the case of the sapphire wafer, e.g., major planes such as a c-plane, an m-plane, or an a-plane can be used. The substrate may have an off-angle with respect to a just surface. The off-angle is preferably 0° to 15°, though not being limited thereto.

The thickness of the substrate 110 is not particularly limited, but from a cost perspective, a thickness of about 200 to 800 µm is preferable. Moreover, an area of the main surface of the substrate 110 (surface on which the crystalline metal oxide film is formed) is preferably 10 cm² or more, and preferably equal to or greater than an area of a circle having a diameter of about 5 cm (2 inches) or more, more preferably an area equal to or greater than a circle having a diameter of about 10 cm (4 inches). Although the upper limit of the area is not particularly limited but preferably 750 cm² or less, and in the case of the substrate having a circular shape, a diameter of 12 inches (300 mm) or less is preferred.

In this way, when the substrate 110 has a large area of 10 cm² or more, a high-quality crystalline metal oxide film can be formed on the substrate 110 having a large area, resulting in particularly high producibility. The shape of the substrate 110 is not particularly limited in the present invention.

The crystalline metal oxide film may be formed directly on the substrate 110, or may be laminated on an intermediate layer (such as a buffer film or a delamination film) formed on the substrate 110. The intermediate layer is not particularly limited, as long as the layer thereof is a metal oxide capable of having a corundum structure and can be composed of an oxide as a main component, containing any of aluminum, titanium, vanadium, chromium, iron, gallium, rhodium, indium, or iridium, for example.

More specifically, the intermediate layer is composed of Al₂O₃, Ti₂O₃, V₂O₃, Cr₂O₃, Fe₂O₃, Ga₂O₃, Rh₂O₃, In₂O₃, or Ir₂O₃, or can be a metal oxide of binary system represented by (AₓB₁₋ₓ)₂O₃ (0<x<1) when 2 elements selected from the above metal elements are defined as A and B, or a metal oxide of ternary system represented by (AₓB_{y}C_{1-x-y})₂O₃ (0<x<1, 0<y<1) when 3 elements selected from the above metal elements are defined as A, B, and C.

In the inventive film forming method, an annealing treatment may be performed following the formation of the crystalline metal oxide film. The temperature of the annealing treatment is not particularly limited, but is preferably 600°C or lower, and more preferably 550°C or lower. This is because of avoiding the degradation of the crystallinity of the film. The treatment time for the annealing treatment is not particularly limited, but is preferably from 10 seconds to 10 hours, and more preferably from 10 seconds to 1 hour.

### [Crystalline Metal Oxide Film]

The crystalline metal oxide film according to the present invention is a crystalline metal oxide film that includes at least one of gallium or aluminum as the main component, in which the number density of the spherical foreign matter or the agglomeration of spherical foreign matter present on the surface of the crystalline metal oxide film is 621 units/cm² or less.

Such a crystalline metal oxide film can be suitably used for the semiconductor device due to the excellent smoothness of the film.

Note that the surface of the crystalline metal oxide film, as referred to in the present invention, is one surface of either the front or back surfaces of the crystalline metal oxide film.

In general, the crystalline metal oxide film is composed of a metal and oxygen. In the crystalline metal oxide film according to the present invention, the metal includes at least one of gallium or aluminum as the main component. The main component referred to here means gallium or aluminum accounts for 50 to 100 atom % of the metal component.

The metallic components other than gallium may include, for example, one or more metals selected from iron, indium, vanadium, titanium, chromium, rhodium, iridium, nickel, and cobalt.

The number density of the spherical foreign matter or the agglomeration of spherical foreign matter present on the film surface of the crystalline metal oxide film is preferably 100 units/cm² or less, more preferably 54 units/cm² or less, and further preferably 8 units/cm² or less. The lower limit of the spherical foreign matter is not particularly limited, but may be 0.01 units/cm² or more.

Such a crystalline metal oxide film has an improved smoothness of the film, and thus can be more suitably used for the semiconductor device.

Moreover, the spherical foreign matter according to the present invention is amorphous particles formed during the film formation as described later. Accordingly, when adhered to or embedded in the film surface, the matter is crystallized by heating. However, at this time, instead of an α-phase, a γ-phase aluminum oxide crystal or a γ-phase gallium oxide crystal, or a mixed crystal thereof is grown. Consequently, when a voltage is applied to the film on which the spherical foreign matter is present, an electric field is concentrated at the grain boundary portion between the α-phase and the γ-phase, resulting in dielectric breakdown with ease. When the number density of the spherical foreign matter or the agglomeration of spherical foreign matter present on the surface is 621 units/cm² or less, dielectric breakdown due to the formation of grain boundaries can be sufficiently suppressed.

Moreover, the crystalline metal oxide film can have the corundum structure.

Such a crystalline metal oxide film can be a crystalline metal oxide film having the corundum structure with excellent smoothness.

The spherical foreign matter in the present invention is a foreign matter originating from the metal raw material, like that shown in FIG. 4. Although the forming mechanism of the spherical foreign matter is not clear, it is considered that the spherical foreign matter is formed, during the film formation, by precipitation of the metal raw material by evaporation of water in the mist, or formation of the metal oxide by side reaction of the metal raw material in the gas phase.

The term spherical in the present invention refers to a shape that looks at least partially like a sphere and includes not only a true sphere but also an oblate spheroid obtained by rotating an ellipse around a minor axis thereof as an axis of rotation, or a prolate spheroid obtained by rotating an ellipse around a major axis thereof as an axis of rotation. Furthermore, shapes such as a hemisphere are included, in which the true sphere, the oblate spheroid, and the prolate spheroid are divided by a plane.

The spherical foreign matter has a spherical equivalent diameter of submicron to 10 µm. Note that the spherical equivalent diameter described here refers to a radius where the spherical foreign matter is regarded as a true sphere. A calculating method of the spherical equivalent diameter is not particularly limited. For example, such a diameter can be calculated by imaging the spherical foreign matter with an electron microscope, such as an SEM, and measuring the radius.

The main component of the spherical foreign matter is an amorphous aluminum oxide or an amorphous gallium oxide.

The method for analyzing composition is not particularly limited. The investigation can be performed by EDX, Auger electron spectroscopy, or SIMS. The method for analyzing crystal structure is also not limited. The common methods, such as electron diffraction, can be employed for investigation.

Moreover, the agglomeration of spherical foreign matter refers to the foreign matter like that shown in FIG. 5, and refers to a foreign matter in which about 2 to 100 units of the spherical foreign matter are agglomerated.

The spherical foreign matter or the agglomeration of spherical foreign matter can be identified in terms of the shape and number thereof by the shape observation or the investigation of the number generated using not only SEM as shown in FIGs. 4 and 5, but also the electron microscope such as TEM, the optical microscope, the surface inspection apparatus that detect defects based on brightness contrast, or the surface inspection apparatus using image recognition AI for defect detection through machine learning. However, the observation method and the method for counting the number of defects are not particularly limited.

Note that a method for determining the shape of the spherical foreign matter is not particularly limited. It can be determined using the electron microscope, the optical microscope, the surface inspection apparatus that detects defects through machine learning based on the defects identified by humans, or the like. Among these, it is preferable to determine by the electron microscope, because the optical method may have difficulty in identification depending on a lighting conditions and a viewing angle. Moreover, a machine learning based surface inspection apparatus provided with a review function using the electron microscope is particularly preferable. This is because an automatic selective counting of the spherical foreign matter is enabled, and is determined using the electron microscope as well, thereby making the inspection accurate and shortened.

The crystalline metal oxide film may contain the dopant depending on an application. The dopant is not particularly limited. For example, n type dopants such as tin, germanium, silicon, titanium, zirconium, vanadium, or niobium, or p type dopants such as copper, silver, tin, iridium, or rhodium can be mentioned. The concentration of the dopant may be, for example, about 1.0×10¹⁶ to 1.0×10²² /cm³, and even the concentration can be as low concentration of about 1.0×10¹⁷ /cm³ or less, or as high concentration of about 1.0×10²⁰ /cm³ or more.

In the crystalline metal oxide film according to the present invention, the film thickness is not particularly limited. For example, the thickness may be 0.05 to 100 µm, preferably 0.1 to 50 µm, and more preferably 0.5 to 20 µm.

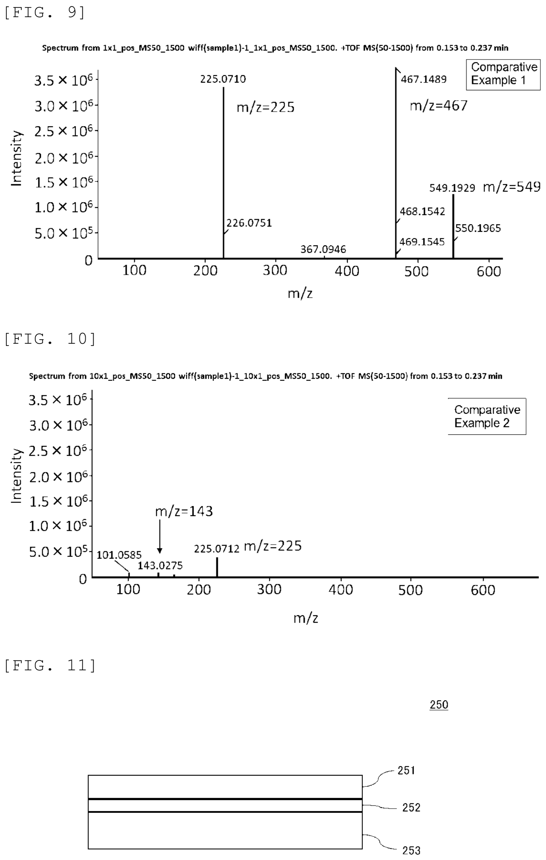

The crystalline metal oxide film may be formed directly on the substrate or may be laminated on an intermediate layer 252 (such as a buffer film or a delamination film) formed on a substrate 253 as shown in FIG. 11. The intermediate layer is not particularly limited, as long as the layer thereof is a metal oxide capable of having a corundum structure and can be composed of an oxide as a main component, containing any of aluminum, titanium, vanadium, chromium, iron, gallium, rhodium, indium, or iridium, for example.

More specifically, the intermediate layer is composed of Al₂O₃, Ti₂O₃, V₂O₃, Cr₂O₃, Fe₂O₃, Ga₂O₃, Rh₂O₃, In₂O₃, or Ir₂O₃, or can be a metal oxide of binary system represented by (AₓB₁₋ₓ)₂O₃ (0<x<1) when 2 elements selected from the above metal elements are defined as A and B, or a metal oxide of ternary system represented by (AₓB_{y}C_{1-x-y})₂O₃ (0<x<1, 0<y<1) when 3 elements selected from the above metal elements are defined as A, B, and C.

The surface area of the crystalline metal oxide film is preferably 10 cm² or more, and in the case of a circular shape, a surface area equivalent to a diameter of 2 inches (50 mm) or more is preferable. Although the upper limit of the area is not particularly limited, the area of 750 cm² or less is preferred, and in the case of a circular shape, a surface area equivalent to a diameter of 12 inches (300 mm) or less is preferable.

Such a crystalline metal oxide film has excellent smoothness and a large area, and thus can be suitably used for the semiconductor device.

The crystalline metal oxide film according to the present invention can be used for the semiconductor device by appropriate structure design. Examples of the semiconductor device will be described in detail later.

### (Method for Producing Crystalline Metal Oxide Film)

As described above, the crystalline metal oxide film according to the present invention can be obtained by appropriately selecting the substrate and the intermediate layer and performing film formation. As described above, the film formation method can be conducted by the Mist CVD method using the appropriate raw material solution.

### (Laminated Structure)

FIG. 11 is a view illustrating a form of a structure of a laminated structure according to the present invention. A laminated structure 250, which has the crystalline metal oxide film according to the present invention, basically includes the substrate 253 and a crystalline metal oxide film 251. In this case, the intermediate layer 252 serving as a buffer layer as described above may be included between the substrate 253 and the crystalline metal oxide film 251.

Such a laminated structure is suitably used for the semiconductor device due to the excellent smoothness of the film.

The crystalline metal oxide film according to the present invention can be used for the semiconductor device by appropriate structure design.
For example, such a film can be used to configure the respective semiconductor layers of a Schottky barrier diode (SBD), a metal semiconductor field effect transistor (MESFET), a high electron mobility transistor (HEMT), a metal oxide semiconductor field effect transistor (MOSFET), a static induction transistor (SIT), a junction field effect transistor (JFET), an insulated gate type bipolar transistor (IGBT), a light emitting diode(LED), and the like.

### (Semiconductor Device)

Moreover, the semiconductor device according to the present invention includes at least one of the crystalline metal oxide film described above or the laminated structure described above. For example, the semiconductor devices (semiconductor element) such as a semiconductor laser, a diode, or a transistor can be provided. Such a semiconductor device may include the substrate or may be a semiconductor device from which the substrate has been removed. The semiconductor device according to the present invention employs a high-quality crystalline metal oxide film with excellent flatness, and is a high-quality semiconductor device with excellent electrical characteristics. Application examples (specific examples) of the semiconductor device are as follows.

### (Example of Applicable Semiconductor Device)

The crystalline metal oxide film and the laminated structure having the crystalline metal oxide film as described above exhibit excellent flatness and superior electrical characteristics, resulting in being industrially useful. Such a crystalline metal oxide film and the laminated structure having the crystalline metal oxide film can be suitably used for various semiconductor devices, and the like, and are particularly useful for a power device.

Moreover, the semiconductor device can be classified into a horizontal-type element (horizontal device), in which electrodes are formed on one side of the crystalline metal oxide film, and a vertical-type element (vertical device), in which electrodes are provided on both the front and back surfaces of the crystalline metal oxide film. The inventive semiconductor device can be suitably used for both the horizontal device and the vertical device; especially, it is preferable to be used for the vertical device. Examples of such semiconductor devices include the Schottky barrier diode (SBD), the metal semiconductor field effect transistor (MESFET), the high electron mobility transistor (HEMT), the semiconductor field effect transistor (MOSFET), the junction field effect transistor (JFET), the insulated gate type bipolar transistor (IGBT), the light emitting diode (LED), and so on.

### (Method for Producing Semiconductor Device)

First, the crystalline metal oxide film is formed on the main surface of the substrate, either directly or via another layer, to obtain the laminated structure according to the present invention. Subsequently, the electrodes, and the like are formed on the crystalline metal oxide film, producing the semiconductor device. At this time, the laminated structure including the substrate and the crystalline metal oxide film can be used as is, or the substrate may be removed to leave the intermediate layer and the crystalline metal oxide film, or both the substrate and the intermediate layer may be removed to leave only the crystalline metal oxide film. In this way, a high-performance semiconductor device can be produced using the high-quality crystalline metal oxide film having excellent flatness.

Hereinafter, the suitable examples will be described with reference to the drawings in which the inventive crystalline metal oxide film is applied to an n type semiconductor layer (such as n+ type semiconductor or n- type semiconductor layer, or the like); however, the present invention is not limited to these examples. Note that in semiconductor elements shown below as examples, another layer (such as an insulator layer or a conductor layer) may be further included, or the intermediate layer or the buffer layer (Buffer Layer) may be omitted as appropriate.

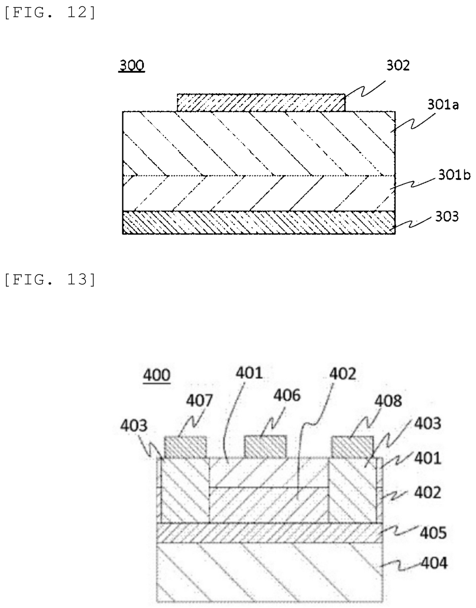

FIG. 12 is an example of an SBD according to the present invention. The SBD 300 is provided with the n-type semiconductor layer 301a that is doped with a relatively low concentration, the n+ type semiconductor layer 301b with a relatively high concentration, a Schottky electrode 302, and an ohmic electrode 303.

The materials for the Schottky electrode 302 and the ohmic electrode 303 may be known electrode materials. Examples of these electrode materials include metals or their alloys such as aluminum, molybdenum, cobalt, zirconium, tin, niobium, iron, chromium, tantalum, titanium, gold, platinum, vanadium, manganese, nickel, copper, hafnium, tungsten, iridium, zinc, indium, palladium, neodymium, or silver. Additionally, conductive metal oxide films such as tin oxide, zinc oxide, rhenium oxide, indium oxide, indium tin oxide (ITO), and zinc indium oxide (IZO), as well as organic conductive compounds like polyaniline, polythiophene, or polypyrrole, may also be used. Mixtures and laminates of the above materials can also be exemplified.

The Schottky electrode 302 and the ohmic electrode 303 can be formed by, for example, known means such as a vacuum deposition method or a sputtering method. More specifically, for example, in the case of forming the Schottky electrode using two kinds of metals i.e., a first metal and a second metal, from the metals described above, the Schottky electrode can be formed by laminating a layer of the first metal and a layer of the second metal and then patterning the layer composed of the first metal and the layer composed of the second metal using a photolithography technique.

When a reverse bias is applied to the SBD 300, a depletion layer (not shown) extends into the n- type semiconductor layer 301a, resulting in a high-voltage SBD. Alternatively, when a forward bias is applied, electrons flow from the ohmic electrode 303 to the Schottky electrode 302. Thus, the SBD of the present invention is excellent for use in high voltage and high current applications, has high switching speed, and has excellent withstand voltage and reliability.

FIG. 13 is an example of a HEMT according to the present invention. A HEMT 400 is provided with a wide bandgap n type semiconductor layer 401, a narrow bandgap n type semiconductor layer 402, an n+ type semiconductor layer 403, a semi-insulator layer 404, a buffer layer 405, a gate electrode 406, a source electrode 407, and a drain electrode 408.

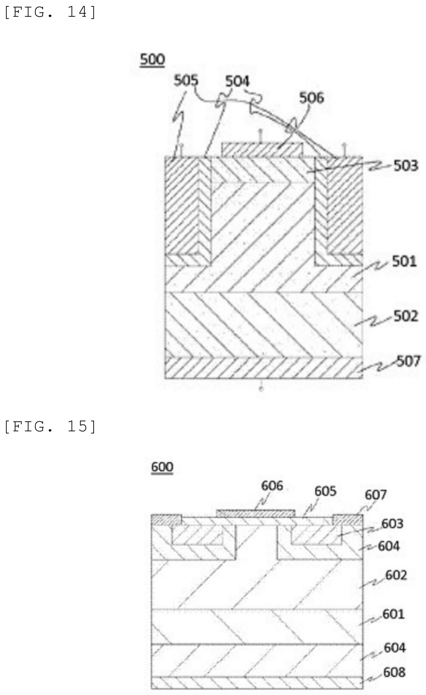

FIG. 14 is an example of a MOSFET according to the present invention. A MOSFET 500 is provided with an n-type semiconductor layer 501, n+ type semiconductor layers 502 and 503, a gate insulator film 504, a gate electrode 505, a source electrode 506, and a drain electrode 507.

FIG. 15 is an example of an IGBT according to the present invention. An IGBT 600 is provided with an n type semiconductor layer 601, an n- type semiconductor layer 602, an n+ type semiconductor layer 603, a p type semiconductor layer 604, a gate insulator film 605, a gate electrode 606, an emitter electrode 607, and a collector electrode 608.

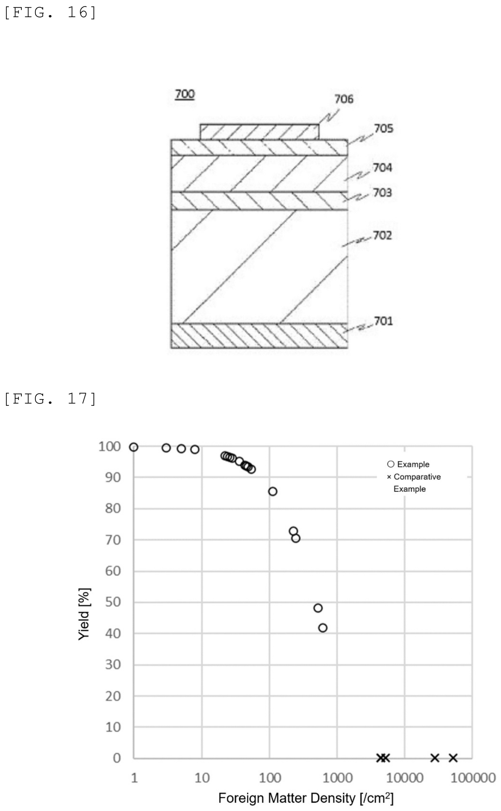

FIG. 16 is an example of an LED according to the present invention. An LED 700 is provided with a first electrode 701, an n type semiconductor layer 702, a light-emitting layer 703, a p type semiconductor layer 704, a transmissive electrode 705, and a second electrode 706. Examples of materials for the transmissive electrode include conductive materials of oxides containing indium or titanium. More specific examples include In₂O₃, ZnO, SnO₂, Ga₂O₃, TiO₂, CeO₂, a mixed crystal of any two or more of them, and these with doped. By processing these materials by known means, such as sputtering, the transmissive electrode can be formed. Moreover, after forming the transmissive electrode, thermal annealing may be applied to make the transmissive electrode transparent.

Examples of materials for the first electrode 701 and the second electrode 706 include metals such as aluminum, molybdenum, cobalt, zirconium, tin, niobium, iron, chromium, tantalum, titanium, gold, platinum, vanadium, manganese, nickel, copper, hafnium, tungsten, iridium, zinc, indium, palladium, neodymium, or silver, alloys of these metals, metal oxide conductive films such as tin oxide, zinc oxide, rhenium oxide, indium oxide, indium tin oxide (ITO), and indium zinc oxide (IZO), organic conductive compounds such as polyaniline, polythiophene, or polypyrrole, or mixtures thereof. The method for forming the electrodes is not particularly limited; the electrodes can be formed on the substrate according to the method that is appropriately selected, in consideration of compatibility with the materials described above, from methods including wet methods such as a printing method, a spraying method, and a coating method, physical methods such as a vacuum deposition method, a sputtering method, and an ion plating method, and chemical methods such as a CVD method and a plasma CVD method.

### (Film Forming Method)

Hereinafter, an example of the film forming method according to the present invention will be described with reference to FIG. 1. First, the raw material solution 104a is stored in the mist generation source 104 of the mist forming unit 120, the substrate 110 (crystalline substrate) is placed on the hot plate 108, and the hot plate 108 is operated.

Next, the flow rate control valves 103a and 103b are opened, and the carrier gas is then supplied from the carrier gas source 102a (main carrier gas) and the diluent carrier gas source 102b (diluent carrier gas) into the film forming chamber 107. Subsequently, the atmosphere in the film forming chamber 107 is sufficiently purged with the carrier gas, and the flow rate of the main carrier gas and the flow rate of the diluent carrier gas are adjusted to control the respective flow rates.

Next, the mist is generated. Specifically, the ultrasonic vibrator 106 is vibrated, and this vibration is propagated to the raw material solution 104a through water 105a, thereby atomizing the raw material solution 104a into the mist to generate the mist.

Next, the mist-transportation is performed by transporting the mist using the carrier gas. Specifically, the mist is transported from the mist forming unit 120 to the film forming unit 140 via the transport portion 109 by the carrier gas, and is then introduced into the film forming chamber 107.

Then, the film formation is performed. Specifically, the mist is supplied onto the substrate 110 placed on the hot plate 108, and is heat-treated to thermally react by heat from the hot plate 108 in the film forming chamber 107, thereby forming the crystalline metal oxide film on the substrate 110. After the film formation, annealing may be performed as needed.

### (Delamination)

After the film formation, the substrate 110 may be delaminated from the crystalline metal oxide film. The means for delamination are not particularly limited, and known means may be used. For example, means to delaminate by applying mechanical impact, means to delaminate by heating to utilize thermal stress, means to delaminate by applying vibration such as ultrasonic waves, means to delaminate by etching, and means to delaminate by performing laser lift-off can be exemplified. By the delamination described above, the crystalline metal oxide film can be obtained as a freestanding film.

### EXAMPLE

Hereinafter, the present invention will be specifically described with reference to Examples. However, the present invention is not limited thereto.

A raw material solution containing a metal raw material and various carboxylic acids in various proportions was atomized into a mist and was subjected to heat treatment to form a crystalline metal oxide film on a substrate. A number of the spherical foreign matter generated on a surface of the film was compared with that of a crystalline metal oxide film formed using a raw material solution containing no carboxylic acid. Moreover, MS spectra of the raw material solutions were compared. Specific procedures were as follows.

### (Example 1)

### 1. Forming Crystalline Metal Oxide Film

A crystalline metal oxide film was formed using a film forming apparatus 100 shown in FIG. 1, following procedures described below.

### 1-1. Step for Producing Raw Material Solution 104a

A solution in which aluminum acetylacetonate, a metal raw material, was added to water, and 15 vol % of a formic acid was added as a carboxylic acid therein. The solution was stirred at 60°C for 120 minutes to dissolve the metal raw material, and an aqueous solution was prepared in which a raw material concentration of the metal raw material as solute was 0.1 mol/L, and this solution was then designated as a raw material solution 104a. The raw material solution 104a obtained as described above was stored in the mist generation source 104. The temperature of the solution at this time was 25°C.

### 1-2. Step for Heating

Next, as the substrate 110, a disk-shaped sapphire substrate having a diameter of 4 inches (100mm) and a main surface thereof being a c-plane was placed on a hot plate 108 in a film forming chamber 107, and the hot plate 108 was operated to raise a temperature to 500°C.

### 1-3. Step for Supplying Carrier Gas

Subsequently, flow rate control valves 103a and 103b were opened to supply nitrogen gas as a carrier gas into the film forming chamber 107 from a carrier gas source 102a (main carrier gas) and a diluent carrier gas source 102b (diluent carrier gas), and atmosphere inside the film forming chamber 107 was sufficiently purged by these carrier gases. In addition, a flow rate of the main carrier gas was adjusted to 12 L/min, and a flow rate of the diluent carrier gas was adjusted to 12 L/min, respectively.

### 1-4. Step for Forming Film

Next, an ultrasonic vibrator 106 was vibrated at 2.4 MHz, and the vibration was propagated to the raw material solution 104a through water 105a, thereby atomizing the raw material solution 104a into mist to generate the mist.

This mist was transported to the film forming chamber 107 through a supply pipe 109a by the carrier gas to supply the mist onto the substrate 110.

Subsequently, under the condition of atmospheric pressure at a temperature of 500°C, while the gas was being exhausted from an exhaust port 112, the mist was thermally reacted inside the film forming chamber 107, thereby forming an α-Al₂O₃ film having a corundum structure on the substrate 110. Film forming time was set to 150 minutes. At this time, in order to maintain a constant surface height level of the raw material solution 104a in the mist generation source 104 during the film formation, the raw material solution 104a was appropriately replenished into the mist generation source 104 using a replenishment mechanism (not shown).

### (Examples 2 to 5)

A film formation was performed in the same way as in Example 1 except that amounts of a formic acid added to a raw material solution 104a in the step 1-1. for producing the raw material solution 104a were set to 0.5 vol % (Example 2), 1 vol % (Example 3), 5 vol % (Example 4), and 25 vol % (Example 5).

### (Comparative Example 1)

A film formation was performed in the same way as in Example 1 except that a hydrochloric acid (acid dissociation constant of -8) was added at 1 vol % instead of a formic acid in the step 1-1. for producing a raw material solution 104a.

### (Examples 6 to 9)

A film formation was performed in the same way as in Example 1 except that a concentration of aluminum acetylacetonate was 0.30 mol/L and additive amounts of a formic acid were 20 vol % (Example 6), 40 vol % (Example 7), 50 vol % (Example 8), and 60 vol % (Example 9) in the step 1-1. for producing a raw material solution 104a, and a film forming temperature were all set to 440°C.

### (Example 10)

A film formation was performed in the same way as in Example 1 except that an acetic acid (acid dissociation constant with respect to water of 4.56) was added at 15 vol % instead of a formic acid in the step 1-1. for producing a raw material solution 104a.

### (Example 11)

A film formation was performed in the same way as in Example 1 except that a propionic acid (3 carbon atoms, an acid dissociation constant with respect to water of 4.67) was added at 15 vol % instead of a formic acid in the step 1-1. for producing a raw material solution 104a.

### (Example 12)

A film formation was performed in the same way as in Example 1 except that a saturated aqueous solution of a malonic acid (acid dissociation constant with respect to water of 2.65) was added at 15 vol % instead of a formic acid in the step 1-1. for producing a raw material solution 104a.

### (Example 13)

A film formation was performed in the same way as in Example 1 except that a 50 wt% aqueous solution of a glyoxylic acid (acid dissociation constant with respect to water of 3.18) was added at 15 vol % instead of a formic acid in the step 1-1. for producing a raw material solution 104a.

### (Comparative Example 2)

A film formation was performed in the same way as in Example 1 except that a hydrochloric acid (acid dissociation constant of -8) was added at 15 vol % instead of a formic acid in the step 1-1. for producing a raw material solution 104a.

### (Comparative Example 3)

A film formation was performed in the same way as in Example 1 except that a hydrobromic acid (acid dissociation constant of -9) was added at 15 vol % instead of a formic acid in the step 1-1. for producing a raw material solution 104a.

### (Comparative Example 4)

A film formation was performed in the same way as in Example 1 except that an acetylacetone (acid dissociation constant of 8.8) was added at 15 vol % instead of a formic acid in the step 1-1. for producing a raw material solution 104a.

### (Example 14)

A film formation was performed in the same way as in Example 1 except that a concentration of an aluminum acetylacetonate was set to 0.08 mol/L and a 50 wt% aqueous solution of glyoxylic acid (acid dissociation constant with respect to water of 3.18) instead of a formic acid was added at 1 vol % in the step 1-1. for producing a raw material solution 104a, and a film forming temperature was set to 400°C.

### (Example 15)

A film formation was performed in the same way as in Comparative Example 1 except that a formic acid was further added at 15 vol % in the step 1-1. for producing a raw material solution 104a.

### (Example 16)

A film formation was performed in the same way as in Example 1 except that a sapphire substrate having a diameter of 6 inches (150 mm) as a substrate 110, a 0.1 mol/L solution of a gallium acetylacetonate as a metal raw material was used in the step 1-1. for producing a raw material solution 104a, a film formation temperature was set to 550°C, and an amount of a carrier gas supplied was doubled.

### (Example 17)

### 2. Formation of AlGaO Film

An AlGaO film was formed according to the following procedure using a film forming apparatus 200 shown in FIG. 3. In this Example 17, a c-plane sapphire substrate having a diameter of 4 inches (100 mm) was first used as a substrate 210.

### 2-1. Step for Producing Raw Material Solution

A solution in which a gallium acetylacetonate, as one of metal raw materials, was added to water, and 15 vol % of a formic acid was added as a carboxylic acid therein. The solution was then stirred at 60°C for 120 minutes to dissolve, and an aqueous solution was prepared in which the raw material concentration was 0.1 mol/L, and this solution was then designated as a Ga raw material solution 204b. The Ga raw material solution 204b obtained as described above was stored in a mist generation source 204a. A temperature of the solution at this time was 25°C.

Subsequently, a solution in which an aluminum acetylacetonate, as one of the metal raw materials, was added to water, and 15 vol % of a formic acid was added as a carboxylic acid therein. The solution was then stirred at 60°C for 120 minutes to dissolve, and an aqueous solution was prepared in which the raw material concentration was 0.1 mol/L, and this solution was then designated as an Al raw material solution 204d. The Al raw material solution 204d obtained as described above was stored in a mist generation source 204c. A temperature of the solution at this time was 25°C.

### 2-2. Step for Heating Substrate

Next, as substrate 210, a c-plane sapphire substrate having a diameter of 4 inches (100mm) was placed on a hot plate 208 in a film forming chamber 207 of a film forming unit 240, and the hot plate 208 was operated to raise a temperature to 440°C.

### 2-3. Step for Supplying Carrier Gas

Next, flow rate control valves 203a, 203b, 203c, and 203d were opened to supply an oxygen gas as a carrier gas into a film forming chamber 207 from a carrier gas source 202a (main carrier gas of Ga) and a diluent carrier gas supply source 202b (diluent carrier gas of Ga) of a carrier gas supply unit 230a and a carrier gas source 202c (main carrier gas of Al) and a diluent carrier gas supply source 202d (diluent carrier gas of Al) of a carrier gas supply unit 230b, and atmosphere inside the film forming chamber 207 was sufficiently purged by these carrier gases. In addition, a flow rate of the main carrier gas of Ga was adjusted to 2 L/min, a flow rate of the diluent carrier gas of Ga was adjusted to 10 L/min, a flow rate of the main carrier gas of Al was adjusted to 10 L/min, and a flow rate of the diluent carrier gas of Al was adjusted to 2 L/min, respectively.

### 2-4. Step for Forming Film

Next, ultrasonic vibrators 206a and 206b were vibrated at 2.4 MHz using oscillators 216a and 216b, and the vibration was propagated to the Ga raw material solution 204b through water 205b in a container 205a and to the Al raw material solution 204d through water 205d in a container 205c, thereby atomizing the Ga raw material solution 204b and the Al raw material solution 204d into mists to generate the mists.

These mists were transported by the carrier gas through transport pipes 209a and 209b of a transport unit 209 to a mist mixer 213, where the mists of the Ga raw material solution 204b and the Al raw material solution 204d were mixed. The mist mixed in the mist mixer 213 was then transported by the carrier gas through a supply pipe 209c of the transport unit 209 to the film forming chamber 207, and the mist was supplied onto the substrate 210.

Subsequently, under the condition of atmospheric pressure at a temperature of 440°C, while the gas was being exhausted from an exhaust port 212, the mist was thermally reacted inside the film forming chamber 207, thereby forming a thin film made from an AlGaO film (α-AlₓGa₁₋ₓ)₂O₃ (0≤x<1) having a corundum structure on the substrate 210. Film forming time was set to 150 minutes. At this time, in order to maintain a constant surface height level of the Ga raw material solution 204b in the mist generation source 204a and the Al raw material solution 204d in the mist generation source 204c during the film formation, the Ga raw material solution 204b and the Al raw material solution 204d were appropriately replenished into the mist generation source 204a and 204c using a replenishment mechanism (not shown), respectively.

### (Comparative Example 5)

A film formation was performed in the same way as in Example 17 except that a HCL was added at 1 vol % instead of a formic acid in the step 2-1. for producing a raw material solution in Example 17.

### (Evaluation)

### 1. Crystal Structure Evaluation

Crystal structures of the produced films were evaluated by a 2θ-ω scan in XRD. The films obtained in Examples 1 to 15 and Comparative Examples 1 to 4 were confirmed to be α-Al₂O₃, the film obtained in Example 16 was confirmed to be α-Ga₂O₃, and the films obtained in Example 17 and Comparative Example 5 were confirmed to be α-(AlₓGa₁₋ₓ)₂O₃ (0<x<1).

### 2. Measurement of Number of Foreign Matter

The number of foreign matter was counted using an optical microscope in dark-field mode at a magnification of twenty times for the crystalline metal oxide films formed in Examples 1 to 17 and Comparative Examples 1 to 5. Total view areas of 0.1 to 1 cm² were observed, and the number of the foreign matter per 1 cm² (i.e., foreign matter density) was calculated.

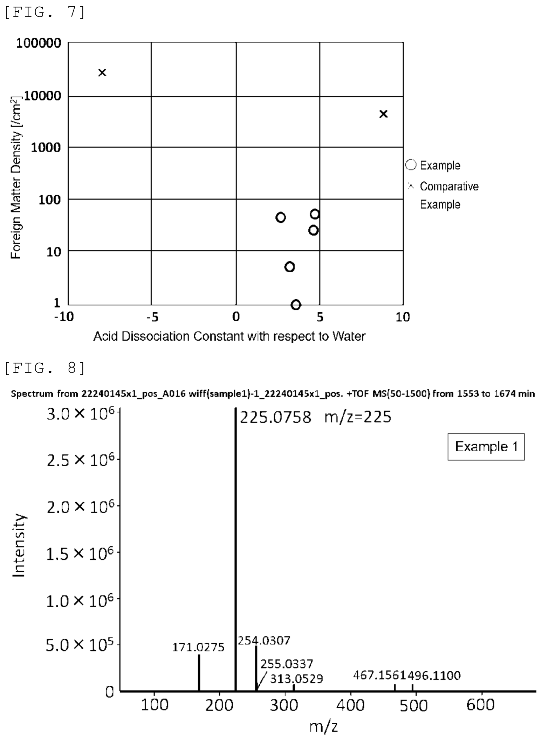

Table 1 shows film-forming conditions and foreign matter densities in Examples 1 to 17 and Comparative Examples 1 to 5. In addition, FIG. 6 shows a relation between the amount of formic acid and the foreign matter density in Examples 1 to 9 and Comparative Examples 1 to 4, and FIG. 7 shows a relation between the acid dissociation constant and the foreign matter density when various acids were added at 15 vol % (Examples 1, 10 to 13, Comparative Examples 2 to 4).

**[Table 1]**

| No. | Metal Type | Acid Type | Acid Dissociat ion Constant with respect to water | Amount Added [vol %] | Carboxylic Acid Concentrati on [mol/L] | Raw Material Concentratio n [mol/L] | Film Forming Temperatu re [°C] | Foreign Matter Density [/cm² ] |
|---|---|---|---|---|---|---|---|---|
| Example 1 | Al | Formic acid | 3.55 | 15 | 3.9 | 0.1 | 500 | <1 |
| Example 2 | Al | Formic acid | 3.55 | 0.5 | 0.1 | 0.1 | 500 | 520 |
| Example 3 | Al | Formic acid | 3.55 | 1 | 0.3 | 0.1 | 500 | 248 |
| Example 4 | Al | Formic acid | 3.55 | 5 | 1.3 | 0.1 | 500 | 36 |
| Example 5 | Al | Formic acid | 3.55 | 25 | 6.6 | 0.1 | 500 | 3 |
| Example 6 | Al | Formic acid | 3.55 | 20 | 5.3 | 0.3 | 440 | 44 |
| Example 7 | Al | Formic acid | 3.55 | 40 | 10.5 | 0.3 | 440 | 22 |
| Example 8 | Al | Formic acid | 3.55 | 50 | 13.2 | 0.3 | 440 | 112 |
| Example 9 | Al | Formic acid | 3.55 | 60 | 15.8 | 0.3 | 440 | 621 |
| Example 10 | Al | Acetic acid | 4.56 | 15 | 2.6 | 0.1 | 500 | 26 |
| Example 11 | Al | Propion ic acid | 4.67 | 15 | 2 | 0.1 | 500 | 54 |
| Example 12 | Al | Malonic acid | 2.65 | 15 | 2 | 0.1 | 500 | 46 |
| Example 13 | Al | Glyoxyl ic acid | 3.18 | 15 | 1.4 | 0.1 | 500 | 5 |
| Example 14 | Al | Glyoxyl ic acid | 3.18 | 1 | 0.1 | 0.08 | 400 | 226 |
| Example 15 | Al | Formic acid+HC 1 | - | 15+1 | 1.3 | 0.1 | 500 | 8 |
| Example 16 | Ga | Formic acid | 3.55 | 15 | 3.9 | 0.1 | 550 | 24 |
| Comparative Example 1 | Al | HCl | -8 | 1 | 0 | 0.1 | 500 | 5247 |
| Comparative Example 2 | Al | HCl | -8 | 15 | 0 | 0.1 | 500 | 28411 |
| Comparative Example 3 | Al | HBr | -9 | 15 | 0 | 0.1 | 500 | 52764 |
| Comparative Example 4 | Al | Hacac | 8.8 | 15 | 0 | 0.1 | 500 | 4541 |
| Example 17 | Ga, Al | Formic acid | 3.55 | 15 | 3.9 | 0.1 | 440 | 28 |
| Comparative Example 5 | Ga, Al | HCl | -8 | 1 | 0 | 0.1 | 440 | 4515 |

As is obvious from Table 1, Examples 1 to 17, in which the carboxylic acid was added to the raw material solution, exhibited significantly lower foreign matter density than Comparative Examples 1 to 5, in which no carboxylic acid was added to the raw material solution.

Moreover, as shown in FIG. 6, although the relation between the amount of formic acid added and the foreign matter density varied depending on the raw material concentration of the metal raw material, the foreign matter density was significantly lower in all of Examples 1 to 9 with an additive amount in a range of 1 to 60 vol % compared to Comparative Examples 1 to 4 in which no carboxylic acid was added.

Furthermore, as shown in FIG. 7, regarding the relation between the acid dissociation constant of the added acid with respect to water and the foreign matter density, the foreign matter density was significantly lower in all cases in the range of acid dissociation constants used in Example 1 and Examples 10 to 13, compared to Comparative Examples 2 to 4, in which no carboxylic acid was added.

Based on the above results, it was found that by adding the carboxylic acid to the raw material solutions, the smooth crystalline metal oxide films were successfully obtained, in which the generation of the foreign matter was suppressed.

### 3. Measurement of MS Spectrum

The MS spectra of the raw material solutions were measured using an electrospray ionization (ESI) method, regarding the raw material solutions 104a used in Example 1, Comparative Example 1, and Comparative Example 2. Note that the measurement conditions were as follows.

### <MS Measurement Conditions>

Sample pretreatment: The samples were used as is for measurement.
Measurement apparatus: Triple TOF 5600+ (manufactured by AB SCIEX PTE. LTD.)
Ionization method: ESI
IonSpray Voltage Floating: 5.5 kV (Positive Mode), 4.5 kV (Negative Mode)
Mass Range: m/z 50 to 1500

The results of detecting cation species in a positive mode are shown in each of FIGs. 8 to 10. In addition, Table 2 shows the relation between peak intensities and (I2+I3+I4) / I1, when the peak intensities at m/z=225, 467, 549, and 143 were defined as I1, I2, I3, and I4, respectively, in Example 1, Comparative Example 1, and Comparative Example 2.

**[Table 2]**

| | I1 (m/z=225) | I2 (m/z=467) | I3 (m/z=549) | I4 (m/z=143) | (I2+I3+I4)/I1 |
|---|---|---|---|---|---|
| Example 1 | 3.1×10⁶ | 1.0×10⁵ | Undetected | Undetected | 0.03 |
| Comparative Example 1 | 3.4×10⁶ | 3.6×10⁶ | 1.7×10⁶ | Undetected | 1.55 |
| Comparative Example 2 | 4.0×10⁵ | Undetected | Undetected | 1.0×10⁵ | 0.25 |

As shown in FIG. 8 and Table 2, in the raw material solution used in Example 1, the peak at m/z=225 was particularly intense, and almost the only peak observed was at m/z=225. This peak is considered to be a peak corresponding to [Al(acac)₂⁺] in which one acac was desorbed from Al(acac)₃, being the raw material.

On the other hand, as shown in FIG. 9 and Table 2, in the raw material solution used in Comparative Example 1, the peaks were observed at m/z=467 and m/z=549 in addition to m/z=225. Each of these peaks is considered to be a peak corresponding to the raw materials having dimerized structures, such as [Al(acac)₂-OH-Al(acac)₂⁺] or [Al(acac)₂-acac-Al(acac)₂⁺], in which [Al(acac)₂⁺] was crosslinked by OH or acac.

Furthermore, as shown in FIG. 10 and Table 2, in the raw material solution used in Comparative Example 2, the peak was observed at m/z=143 in addition to m/z=225. This peak is considered to be a peak corresponding to [Al (acac) (OH)⁺], in which acac in [Al (acac) ₂⁺] was substituted with OH. Note that the peak intensity of the solution in Comparative Example 2 was low due to ionization being inhibited by a high concentration of hydrochloric acid.

As shown in Table 2, when the peak intensity at m/z=225 is defined as I1, the peak intensity at m/z=467 is defined as I2, the peak intensity at m/z=549 is defined as I3, and the peak intensity at m/z=143 is defined as I4, (I2+I3+I4) / I1 = 0.03 in Example 1, and (I2+I3+I4) / I1 ≥ 0.25 in Comparative Examples 1 and 2.

When other raw material solutions in Examples 2 to 15, and 17, Comparative Examples 3 and 4 were analyzed in the same way, (I2+I3+I4) / I1 < 0.25 in Examples, and the minimum value was 0 (I2, I3, and I4 were all less than 5.0×10³, the lower limit of detection). On the other hand, (I2+I3+I4) / I1 ≥ 0.25 in both of Comparative Examples 3 and 4.

As shown in the above MS spectrum measurement results, Examples 1 to 17, to which the carboxylic acid was added, exhibited lower (I2+I3+I4) / I1 compared to Comparative Examples, to which the carboxylic acid was not added. In addition, the peak (m/z=467) attributed to the structure in which the metal raw material was crosslinked with OH or acetylacetonate, the peak (m/z=549) attributed to the dimerized structure, and the peak (m/z=143) attributed to the structure in which acetylacetonate was substituted with OH were scarcely detected, and the foreign matter density was also low. In contrast, in Comparative Examples 1 to 5 to which the carboxylic acid was not added, these peaks were detected, and the foreign matter density was higher than in Examples 1 to 17.

Accordingly, it was suggested that the structures of the metal raw materials indicated by m/z=467, m/z=549, and m/z=143 caused the generation of the foreign matter. It was also suggested that the generation of these structures was suppressed by the carboxylic acid, thereby suppressing the formation of the foreign matter.

### 4. Electric Characteristic Evaluation

By using the crystalline metal oxide film obtained as described above, a semiconductor device (SBD) as shown in FIG. 12 was produced.

### <Forming Schottky Electrode>

A Pt layer, a Ti layer, and an Au layer were laminated on the n- type semiconductor layer using an electron beam evaporation method, respectively.

### <Forming Ohmic Electrode>

A Ti layer and an Au layer were laminated on an n+ type semiconductor layer using the electron beam evaporation method, respectively.

### <Evaluation>

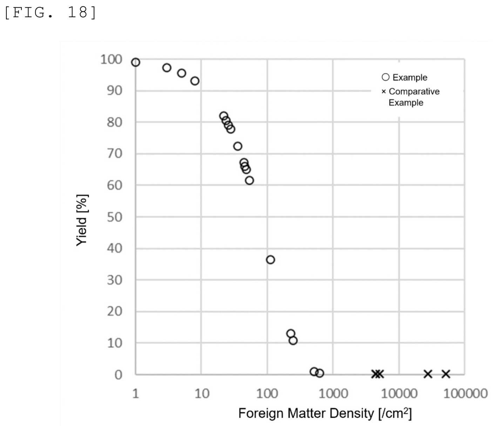

The current-voltage characteristics of the obtained semiconductor devices were evaluated. The voltage at which dielectric breakdown occurred was determined by measuring the current-voltage characteristics in a reverse direction. The semiconductor device having a breakdown voltage of 600 V or more was regarded as a passed product, and a yield was calculated as: the number of passed products / the total number of produced semiconductor devices = yield [%]. A plot of the yield with respect to the foreign matter density calculated in Evaluation 2. is shown in FIG. 17. Moreover, the semiconductor device having a breakdown voltage of 1200 V or more was regarded as a passed product, and a yield was calculated as: the number of passed products / the total number of produced semiconductor devices = yield [%]. A plot of the yield with respect to the foreign matter density calculated in Evaluation 2. is shown in FIG. 18.

Based on a comparison between Examples 1 to 17 and Comparative Examples 1 to 5, it is suggested that the crystalline metal oxide film according to the present invention forms a film having excellent smoothness, enabling the production of the semiconductor device having high breakdown voltage at a high yield. In addition, it is also suggested that the dielectric breakdown caused by the spherical foreign matter tends to occur readily as the breakdown voltage increases.

The present description includes the following embodiments.
[1]: A film forming method for forming a crystalline metal oxide film on a substrate by heat treatment of a raw material solution atomized into a mist to generate a thermal reaction on the substrate, wherein
   the raw material solution contains a metal raw material containing at least a metal element constituting the crystalline metal oxide film, and a carboxylic acid.
[2]: The film forming method according to the above [1], wherein
   the carboxylic acid having an acid dissociation constant with respect to water at 25°C of 2.65 or more and 4.67 or less is used.
[3]: The film forming method according to the above [1] or [2], wherein
   the carboxylic acid having 4 or fewer carbon atoms is used.
[4]: The film forming method according to any one of the above [1] to [3], wherein
   a formic acid is used as the carboxylic acid.
[5]: The film forming method according to any one of the above [1] to [4], wherein
   a volume ratio of the carboxylic acid in the raw material solution is 1 vol % or more and 50 vol % or less.
[6]: The film forming method according to any one of the above [1] to [5], wherein
   a molarity of the carboxylic acid in the raw material solution is 0.1 mol/L or more and 13.2 mol/L or less.
[7]: The film forming method according to any one of the above [1] to [6], wherein
   a molarity of the carboxylic acid in the raw material solution is equal to or higher than a molarity of the metal raw material in the raw material solution.
[8]: A film forming method for forming a crystalline metal oxide film on a substrate by heat treatment of a raw material solution atomized into a mist to generate a thermal reaction on the substrate, wherein
   the raw material solution contains a metal raw material containing at least a metal element constituting the crystalline metal oxide film, and an acid having an acid dissociation constant with respect to water at 25°C of more than -8 and less than 8.8.
[9]: The film forming method according to any one of the above [1] to [8], wherein
   the metal raw material in the raw material solution comprises at least one of gallium or aluminum as a main component.
[10]: The film forming method according to any one of the above [1] to [9], wherein
   the metal raw material is an acetylacetonato complex.
[11]: The film forming method according to any one of the above [1] to [10], wherein
   the raw material solution is a solution containing an acetylacetonato complex of aluminum, and
   in MS spectrum of the raw material solution, when a peak intensity at m/z=225 is defined as I1, a peak intensity at m/z=467 is defined as I2, a peak intensity at m/z=549 is defined as I3, and a peak intensity at m/z=143 is defined as I4, (I2+I3+I4) / I1 < 0.25 is satisfied.
[12]: The film forming method according to any one of the above [1] to [11], wherein
   a temperature of the heat treatment is 400°C or higher and 550°C or lower.
[13]: The film forming method according to any one of the above [1] to [12], wherein
   the substrate having an area of 10 cm² or more of a surface where the crystalline metal oxide film is formed is used.
[14]: A raw material solution used in a film forming method for forming a crystalline metal oxide film on a substrate by heat treatment of a raw material solution atomized into a mist to generate a thermal reaction on the substrate, the raw material solution comprising:
   a metal raw material that contains a metal element constituting the crystalline metal oxide film; and
   a formic acid.
[15]: A raw material solution used in a film forming method for forming a crystalline metal oxide film on a substrate by heat treatment of a raw material solution atomized into a mist to generate a thermal reaction on the substrate, the raw material solution comprising:
   a metal raw material that contains a metal element constituting the crystalline metal oxide film; and
   an acid having an acid dissociation constant with respect to water at 25°C of more than -8 and less than 8.8.
[16]: The raw material solution according to the above [14] or [15], wherein
   the metal raw material in the raw material solution comprises at least one of Ga or Al as a main component.
[17]: The raw material solution according to any one of the above [14] to [16], wherein
   the metal raw material is an acetylacetonato complex.
[18]: The raw material solution according to any one of the above [14] to [17], wherein
   the raw material solution is a solution containing an acetylacetonato complex of aluminum, and
   in MS spectrum of the raw material solution, when a peak intensity at m/z=225 is defined as I1, a peak intensity at m/z=467 is defined as I2, a peak intensity at m/z=549 is defined as I3, and a peak intensity at m/z=143 is defined as I4, (I2+I3+I4) / I1 < 0.25 is satisfied.
[19]: A crystalline metal oxide film comprising at least one of gallium or aluminum as a main component, wherein
   a number density of a spherical foreign matter or an agglomeration of spherical foreign matter present on a surface of the crystalline metal oxide film is 621 units/cm² or less.
[20]: The crystalline metal oxide film according to the above [19], wherein
   the number density of the spherical foreign matter or the agglomeration of spherical foreign matter present on the surface of the crystalline metal oxide film is 54 units/cm² or less.
[21]: The crystalline metal oxide film according to the above [19] or [20], wherein
   the crystalline metal oxide film has a corundum structure.
[22]: The crystalline metal oxide film according to any one of the above [19] to [21], wherein
   a surface area of the crystalline metal oxide film is 10 cm² or more.
[23]: A laminated structure comprising:
   a substrate; and
   the crystalline metal oxide film according to any one of the above [19] to [22], formed via a buffer layer on the substrate.
[24]: A semiconductor device comprising at least one of the crystalline metal oxide film according to any one of the above [19] to [22] or the laminated structure according to the above [23].
[25]: The semiconductor device according to the above [24], wherein
   the semiconductor device is any of a semiconductor laser, a diode, or a transistor.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A film forming method for forming a crystalline metal oxide film on a substrate by heat treatment of a raw material solution atomized into a mist to generate a thermal reaction on the substrate, wherein
the raw material solution contains a metal raw material containing at least a metal element constituting the crystalline metal oxide film, and a carboxylic acid.

2. The film forming method according to claim 1, wherein
the carboxylic acid having an acid dissociation constant with respect to water at 25°C of 2.65 or more and 4.67 or less is used.

3. The film forming method according to claim 1, wherein
the carboxylic acid having 4 or fewer carbon atoms is used.

4. The film forming method according to claim 1, wherein
a formic acid is used as the carboxylic acid.

5. The film forming method according to claim 1, wherein
a volume ratio of the carboxylic acid in the raw material solution is 1 vol % or more and 50 vol % or less.

6. The film forming method according to claim 1, wherein
a molarity of the carboxylic acid in the raw material solution is 0.1 mol/L or more and 13.2 mol/L or less.

7. The film forming method according to claim 1, wherein
a molarity of the carboxylic acid in the raw material solution is equal to or higher than a molarity of the metal raw material in the raw material solution.

8. A film forming method for forming a crystalline metal oxide film on a substrate by heat treatment of a raw material solution atomized into a mist to generate a thermal reaction on the substrate, wherein
the raw material solution contains a metal raw material containing at least a metal element constituting the crystalline metal oxide film, and an acid having an acid dissociation constant with respect to water at 25°C of more than -8 and less than 8.8.

9. The film forming method according to any one of claims 1 to 8, wherein
the metal raw material in the raw material solution comprises at least one of gallium or aluminum as a main component.

10. The film forming method according to claim 9, wherein
the metal raw material is an acetylacetonato complex.

11. The film forming method according to claim 10, wherein
the raw material solution is a solution containing an acetylacetonato complex of aluminum, and
in MS spectrum of the raw material solution, when a peak intensity at m/z=225 is defined as I1, a peak intensity at m/z=467 is defined as I2, a peak intensity at m/z=549 is defined as I3, and a peak intensity at m/z=143 is defined as I4, (I2+I3+I4) / I1 < 0.25 is satisfied.

12. The film forming method according to claim 1 or 8, wherein
a temperature of the heat treatment is 400°C or higher and 550°C or lower.

13. The film forming method according to claim 1 or 8, wherein
the substrate having an area of 10 cm² or more of a surface where the crystalline metal oxide film is formed is used.

14. A raw material solution used in a film forming method for forming a crystalline metal oxide film on a substrate by heat treatment of a raw material solution atomized into a mist to generate a thermal reaction on the substrate, the raw material solution comprising:
a metal raw material that contains a metal element constituting the crystalline metal oxide film; and
a formic acid.

15. A raw material solution used in a film forming method for forming a crystalline metal oxide film on a substrate by heat treatment of a raw material solution atomized into a mist to generate a thermal reaction on the substrate, the raw material solution comprising:
a metal raw material that contains a metal element constituting the crystalline metal oxide film; and
an acid having an acid dissociation constant with respect to water at 25°C of more than -8 and less than 8.8.

16. The raw material solution according to claim 14 or 15, wherein
the metal raw material in the raw material solution comprises at least one of Ga or Al as a main component.

17. The raw material solution according to claim 16, wherein
the metal raw material is an acetylacetonato complex.

18. The raw material solution according to claim 17, wherein
the raw material solution is a solution containing an acetylacetonato complex of aluminum, and
in MS spectrum of the raw material solution, when a peak intensity at m/z=225 is defined as I1, a peak intensity at m/z=467 is defined as I2, a peak intensity at m/z=549 is defined as I3, and a peak intensity at m/z=143 is defined as I4, (I2+I3+I4) / I1 < 0.25 is satisfied.

19. A crystalline metal oxide film comprising at least one of gallium or aluminum as a main component, wherein
a number density of a spherical foreign matter or an agglomeration of spherical foreign matter present on a surface of the crystalline metal oxide film is 621 units/cm² or less.

20. The crystalline metal oxide film according to claim 19, wherein
the number density of the spherical foreign matter or the agglomeration of spherical foreign matter present on the surface of the crystalline metal oxide film is 54 units/cm² or less.

21. The crystalline metal oxide film according to claim 19, wherein
the crystalline metal oxide film has a corundum structure.

22. The crystalline metal oxide film according to claim 19, wherein
a surface area of the crystalline metal oxide film is 10 cm² or more.

23. A laminated structure comprising:
a substrate; and
the crystalline metal oxide film according to claim 19, formed via a buffer layer on the substrate.

24. A semiconductor device comprising at least one of the crystalline metal oxide film according to any one of claims 19 to 22 or the laminated structure according to claim 23.

25. The semiconductor device according to claim 24, wherein
the semiconductor device is any of a semiconductor laser, a diode, or a transistor.
